# EUROPEAN PATENT APPLICATION

(11) **EP 4 290 542 A2**
(43) Date of publication of application: **13.12.2023**
(21) Application number: 23166806.2
(22) Date of filing: 05.04.2023
(51) Int. Cl.: H01G 4/10, H01G 4/12, H01G 4/33, H01G 4/40

(54) **THIN LAYER METAL OXIDE CAPACITOR, ELECTRONIC DEVICE INCLUDING THE SAME (DRAM), AND METHOD OF PREPARING THE SAME**

(30) Priority: 09.06.2022 KR 20220070299; 29.11.2022 KR 20220163421
(71) Applicant: Samsung Electronics Co., Ltd., Suwon-si, Gyeonggi-do 16677 (KR)
(72) Inventor: KIM, Jinhong, 16678, Suwon-si, (KR); LEE, Changsoo, 16678, Suwon-si, (KR); KIM, Cheheung, 16678, Suwon-si, (KR); LEE, Jooho, 16678, Suwon-si, (KR); CHO, Yong-Hee, 18448, Hwaseong-si, (KR)
(74) Representative: Elkington and Fife LLP

(57) **Abstract**

A thin film capacitor (29) including a first thin-film electrode layer (11), a second thin-film electrode layer (13), a dielectric layer (12) between the first and second thin-film electrode layers, and a first interlayer between the first thin-film electrode layer and the dielectric layer and/or between the second thin-film electrode layer and the dielectric layer may be provided. The first interlayer includes a first metal oxide, the first and second thin-film electrode layers (11, 13) includes second metal having a conductive rutile (MO₂) crystal structure The dielectric layer (12) includes a third metal oxide having a dielectric rutile crystal structure, and the first metal oxide, the second metal oxide, and third metal oxide have different compositions from each other. The first metal oxide includes GeO₂, the third metal oxide includes TiO₂, and a thickness of the first interlayer is smaller than that of the dielectric layer. A DRAM comprising the capacitor.

## Description

### FIELD OF THE INVENTION

The disclosure relates to capacitors, devices including the same, and/or methods of manufacturing the capacitors.

### BACKGROUND OF THE INVENTION

Semiconductor devices such as memories and transistors are used in various household and industrial devices. According to the high performance of household and industrial devices, high integration and miniaturization of semiconductor devices are progressing.

According to the high integration and miniaturization of semiconductor devices, the sizes of semiconductor devices are being reduced. For example, since the capacitance of a capacitor decreases and the leakage current increases as the size of the capacitor decreases, various methods have been proposed to solve these problems.

For example, by increasing the electrode area of a capacitor or reducing the thickness of a dielectric to change the structure of the capacitor, or by improving a capacitor manufacturing process, the capacitance of the capacitor is maintained.

### SUMMARY OF THE INVENTION

However, structural improvements, such as increasing an electrode area of a capacitor or reducing a thickness of a dielectric, or improvements in a manufacturing process have a limit to maintaining capacitance of a capacitor.

Dielectrics with higher dielectric permittivity may be used sequentially for higher capacitance. For example, Al₂O₃ having higher dielectric permittivity than SiO₂ may be used, and ZrO₂ having higher dielectric permittivity than Al₂O₃ may be used. TiO₂ has high dielectric permittivity among binary oxides, and in detail, TiO₂ having an anatase crystal structure may have dielectric permittivity of about 40, and TiO₂ having a rutile crystal structure may have high dielectric permittivity in a range of 80 to 170 according to the growth direction.

When a noble metal oxide is used as a lower electrode for depositing the dielectric layer, a TiO₂ dielectric layer having a rutile crystal structure may be deposited at a low temperature in a range of 200 °C to 300 °C. However, a noble metal oxide is expensive, and may be easily reduced during a device manufacturing process following the formation of a capacitor. The reduction of the noble metal causes a volume change in a capacitor, leading to generation of defects in a device.

When a non-noble metal oxide is used as a lower electrode, work function of the lower electrode decreases during a capacitor manufacturing process, so that leakage current between the lower electrode and the dielectric layer increases.

Therefore, there is a need for a new capacitor in which, by having a new structure compared to capacitors in the art, an electrode including a noble metal oxide is not used and leakage current between an electrode and a dielectric layer is suppressed.

Some example embodiments provide capacitors, devices including the same, and/or methods manufacturing the capacitors. According to such example embodiments, leakage current between an electrode and a dielectric layer may be suppressed and deterioration of an electrode may be suppressed during a manufacturing process of a device including the capacitor.

According to an example embodiment, a capacitor may include a first thin-film electrode layer, a second thin-film electrode layer, a dielectric layer between the first thin-film electrode layer and the second thin-film electrode layer, and a first interlayer being at least one of between the first thin-film electrode layer and the dielectric layer and between the second thin-film electrode layer and the dielectric layer, the first interlayer including first metal oxide. At least one of the first thin-film electrode layer and the second thin-film electrode layer may include second metal oxide having a rutile crystal structure and including non-noble metal, the dielectric layer may include third metal oxide having a dielectric rutile crystal structure, the first metal oxide, the second metal oxide, and the third metal oxide may have different compositions from one another, the first metal oxide includes GeO₂, and the third metal oxide may include TiO₂, and a thickness of the first interlayer is smaller than that of the dielectric layer.

Proposed embodiments may be manufactured in the form of a chip to be mounted as a capacitor of next-generation DRAM.

Some embodiment may propose a method of utilizing a transition metal oxide of a rutile structure as an electrode in behalf of the conventional noble metal oxides. The transition metal oxide may include Ta-doped SnO₂ and MoO₂, which are electrodes that are theoretically suitable for the rutile TiO₂ dielectric, because they have a high WF that is similar to the noble metal oxides. In practice, however, a leakage current that is much higher than that of noble metal oxide may be observed, which is because of the transfer of oxygen ions to TiO₂ due to the oxygen chemical potential difference at the interface between the electrode and the dielectric. The oxygen transfer may cause the reduction of the oxide electrode to a metal. While noble metals have a high WF as a metal, the WF of transition metals is decreased by more than 1 eV after being reduced. To prevent the decrease, proposed embodiments may employ an inserted film that is reduced instead of the oxide electrode without disrupting the growth of the rutile structure.

Accordingly, there may be provided a capacitor structure formed by inserting an interlayer between an electrode layer and a dielectric layer in an MIM capacitor structure. The bottom electrode may have a rutile structure and be made of a non-noble metal oxide.

The capacitor may include multiple first thin-film electrode layers that are spaced apart or multiple second thin-film electrode layers that are spaced apart. The capacitor may further include a bridge connecting the multiple first thin-film electrode layers to each other or connecting the multiple second thin-film electrode layers to each other, and the first interlayer may be on the bridge.

The first interlayer may extend from at least one of the multiple first thin-film electrode layers to another adjacent one of the multiple first thin-film electrode layers through the bridge or from at least one of the multiple second thin-film electrode layers to another adjacent one of the multiple second thin-film electrode layers through the bridge, and the first interlayer may be dielectric.

The thickness of the first interlayer may be smaller than at least one of that of the first thin-film electrode layer and that of the second thin-film electrode layer.

The thickness of the first interlayer may be about 1 Å or more to about less than 20 Å.

The first interlayer may be a crystalline layer having a rutile crystal structure or an amorphous layer.

Chemical potential of the first metal oxide may be higher than that of the second metal oxide and that of the third metal oxide, and chemical potential of the second metal oxide is higher than that of the third metal oxide.

The first interlayer may have a defect, and the defect may include oxygen vacancy.

The first metal oxide may further include at least one selected from SnO₂, MnO₂, GeO₂₋ₐ (1 <a<2), SnO₂₋ₐ (1 <a<2), and MnO₂₋ₐ (1 <a<2).

The second metal oxide may include at least one selected from MoO₂, SnO₂, Sn₁₋ₓTaₓO₂ (0.01≤x≤0.1), Sn₁₋ₓNbₓO₂ (0.01≤x≤0.1), Sn₁₋ₓSbₓO₂ (0.01≤x≤0.1), Sn₁₋ₓMnₓO₂ (0.01≤x≤0.1), and Sn₁₋ₓFeₓO₂ (0.01≤x≤0.1).

The third metal oxide may include at least one selected from Ti_{1-y}Ga_{y}O₂ (0.01≤y≤0.1), Ti_{1-y}Al_{y}O₂ (0.01 ≤y≤0.1), Ti_{1-y}La_{y}O₂ (0.01 ≤y≤0.1), Ti_{1-y}B_{y}O₂ (0.01 ≤y≤0.1), Ti_{1-y}In_{y}O₂ (0.01≤y≤0.1), Ti_{1-y}Sc_{y}O₂ (0.01 ≤y≤0.1), and Ti_{1-y}Y_{y}O₂ (0.01≤y≤0.1).

A thickness of the dielectric layer may be in a range of about 2 nm to about 100 nm, and a thickness of each of the first thin-film electrode layer and the second thin-film electrode layer may be in a range of about 10 nm to about 1,000 nm.

At least one of the first thin-film electrode layer and the second thin-film electrode layer may have a multi-layer structure, and the capacitor may further include a second interlayer between multiple sub-electrodes that constitute at least one of the first thin-film electrode layer and second thin-film electrode layer.

At least one of the first thin-film electrode layer and the second thin-film electrode layer that is not in contact with the first interlayer may include at least one selected from metal, oxide of the metal, doped oxide of the metal, nitride of the metal, and carbide of the metal, the metal may include at least one selected from Ti, W, Ta, Co, Mo, Ni, V, Hf, Al, Cu, Pt, Pd, Ir, Au, and Ru, the oxide of the metal may include at least one selected from MoO₂, VO₂, RuO₂, IrO₂, PtO₂, MnO₂, Sb₂O₃, In₂O₃, the doped oxide of the metal may include at least one selected from Ta-doped SnO₂, Sb-doped SnO₂, Ni-doped SnO₂, Ti-doped In₂O₃, Ni-doped SnO₂, Sb-doped SnO₂, and Al-doped ZnO, and the nitride of the metal may include at least one selected from TiN, WN, VN, MoN, TaN, TiAlN, TaSiN, TiSiN, WSiN, TiCN, TiAlCN, RuCN, and RuTiN.

According to an example embodiment, there is provided an electronic device including a transistor and the aforementioned capacitor that is electrically connected to the transistor.

The transistor may include a semiconductor substrate including a source region, a drain region, and a channel region being between the source region and the drain region, and a gate stack being on the semiconductor substrate, facing the channel region, and comprising a gate insulating layer and a gate electrode.

The transistor may include a semiconductor substrate including a source region, a drain region, and a channel region being between the source region and the drain region, and a gate stack being in a trench inserted at a depth from a surface of the semiconductor substrate, facing the channel region, and including a gate insulating layer and a gate electrode.

The electronic device may further include a memory cell including the capacitor and the transistor, and a processor electrically connected to the memory unit and configured to control the memory cell.

According to an example embodiment, a method of preparing a capacitor may include providing one of a first thin-film electrode layer and a second thin-film electrode layer, first-disposing a first interlayer on one surface of the provided one of the first thin-film electrode layer and the second thin-film electrode layer, by epitaxy growth, second-disposing a dielectric layer on the first interlayer by epitaxy growth, and third-disposing the other one of the first thin-film electrode layer and the second thin-film electrode layer on the dielectric layer to provide the capacitor, which includes the first thin-film electrode layer, a second thin-film electrode layer, a dielectric layer disposed between the first thin-film electrode layer and the second thin-film electrode layer. The first interlayer may include first metal oxide, at least one of the first thin-film electrode layer and the second thin-film electrode layer may include second metal oxide having a rutile crystal structure and including non-noble metal, the dielectric layer may include third metal oxide having a dielectric rutile crystal structure, the first metal oxide, the second metal oxide, and the third metal oxide may have different compositions from one another, the first metal oxide may include GeO₂, and the third metal oxide may include TiO₂, and a thickness of the first interlayer may be smaller than that of the dielectric layer.

The providing and the first-disposing may include providing multiple first thin-film electrode layers that are spaced apart or multiple second thin-film electrode layers that are spaced apart, disposing a bridge at least one of between the multiple first thin-film electrode layers to connect the multiple first thin-film electrode layers to each other and between the multiple second thin-film electrode layers to connect the multiple second thin-film electrode layers to each other, and simultaneously disposing the first interlayer by epitaxy growth on one surface of the multiple first thin-film electrode layers or the multiple second thin-film electrode layers and on the bridge disposed between the multiple first thin-film electrode layers or between the multiple second thin-film electrode layers.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a schematic cross-sectional view showing a structure of a capacitor according to an example embodiment;
FIG. 2A is an HR-TEM image of a cross-section of a laminate of electrode /interlayer/dielectric layer prepared in Example 4;
FIG. 2B is an HAADF-STEM image of a cross-section of a laminate of electrode /interlayer/dielectric layer prepared in Example 4;
FIGS. 2C and 2D are each an EDS elemental mapping image of a cross-section of the laminate of electrode/interlayer/dielectric layer of FIG. 2B, confirming that,
as shown in FIGS. 2A to 2F, a GeO₂ interlayer is disposed at an interface between an MoO₂ electrode layer and an Al-doped TiO₂ dielectric layer;
FIG. 3 shows grazing incidence X-ray diffraction (GI-XRD) spectra of capacitors prepared in Examples 1 to 4;
FIG. 4 is a graph showing leakage current according to equivalent oxide thickness (EOT) for capacitors prepared in Examples 5 to 8 and Comparative Examples 1 to 4;
FIG. 5 is a graph showing capacitance and dissipation factor (DF) according to voltage change for capacitors prepared in Example 7 and Comparative Example 3;
FIG. 6 is a graph showing results of chemical potential (µₒ) calculation for a binary oxide having a rutile crystal structure;
FIG. 7 is a graph showing results of local density of state (LDOS) calculation in a case where a GeO₂ layer is inserted between TiO₂ layers;
FIG. 8 is a graph showing leakage current according to a thickness of a GeO₂ interlayer for capacitors prepared in Examples 9 to 14 and Comparative Example 5;
FIG. 9 is a graph showing leakage current according to a thickness of a GeO₂ interlayer for capacitors prepared in Reference Examples 1 and 2;
FIGS. 10A to 10D are each a schematic view of a capacitor according to an example embodiment;
FIG. 11 is a schematic view of a capacitor according to another example embodiment;
FIG. 12 is a circuit diagram illustrating a schematic circuit configuration and operation of an electronic device including the capacitor according to an example embodiment;
FIG. 13 is a schematic view of an electronic device according to an example embodiment;
FIG. 14 is a schematic view of an electronic device according to another example embodiment;
FIG. 15 is a plan view of an electronic device according to another example embodiment;
FIG. 16 is a cross-sectional view taken along line A-A' of FIG. 15;
FIG. 17 is a cross-sectional view of an electronic device according to another example embodiment;
FIG. 18 is a conceptual diagram schematically showing a device architecture that is applicable to a device according to an example embodiment; and
FIG. 19 is a conceptual diagram schematically showing a device architecture that is applicable to a device according to another example embodiment.

### DETAILED DESCRIPTION

Reference will now be made in detail to some example embodiments, examples of which are illustrated in the accompanying drawings, wherein like reference numerals refer to like elements throughout. In this regard, the present example embodiments may have different forms and should not be construed as being limited to the descriptions set forth herein. Accordingly, the example embodiments are merely described below, by referring to the figure, to explain aspects. As used herein, the term "and/or" includes any and all combinations of one or more of the associated listed items. Expressions such as "at least one of A and B (as well as "at least one of A or B") when preceding a list of elements, modify the entire list of elements and do not modify the individual elements of the list.

The present inventive concepts described hereinbelow may have various modifications and various example embodiments, the disclosed example embodiments will be illustrated in the drawings and more fully described. The present inventive concepts may, however, should not be construed as limited to the example embodiments set forth herein, and rather, should be understood as covering all modifications, equivalents, or alternatives falling within the scope of the present inventive concepts.

The terms used herein is for the purpose of describing particular example embodiments only, and is not intended to be limiting the present inventive concepts. An expression used in the singular encompasses the expression of the plural, unless it has a clearly different meaning in the context. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof. As used herein, "/" may be interpreted as "and", or as "or" depending on the context.

In the drawings, thicknesses may be magnified or exaggerated to clearly illustrate various layers and regions. Like reference numbers may refer to like elements throughout the drawings and the following description. It will be understood that when one element, layer, film, section, sheet, etc. is referred to as being "on" another element, it can be directly on the other element or intervening elements may be present therebetween. Although the terms "first," "second," etc. may be used herein to describe various elements, these elements should not be limited by these terms. These terms are only used to distinguish one element from another element. In the present specification and drawings, components having substantially the same functional features are referred to the same reference numerals, and thus repeated descriptions will be omitted.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

Hereinafter, some example embodiments of capacitors, devices including the same, and/or methods of preparing the capacitor will be described in greater detail.

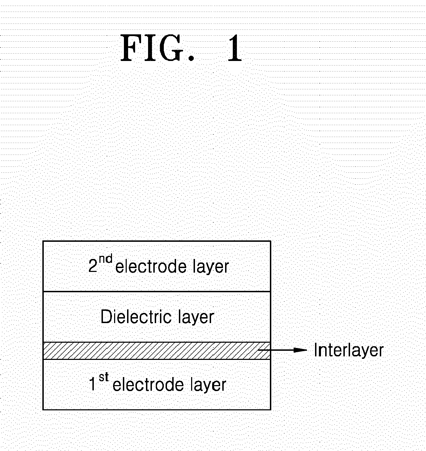

An aspect of the disclosure provides a capacitor including a first thin-film electrode layer, a second thin-film electrode layer, and a dielectric layer disposed therebetween. The capacitor may further include a first interlayer disposed at least one of between the first thin-film electrode layer and the dielectric layer or between the second thin-film electrode layer and the dielectric layer. The first interlayer may include first metal oxide, at least one of the first thin-film electrode layer and the second thin-film electrode layer may include second metal having a conductive rutile crystal structure, and including non-noble metal, the dielectric layer may include third metal oxide having a dielectric rutile crystal structure, and the first metal oxide, the second metal oxide, and third metal oxide may have different compositions from each other. The first metal oxide may include GeO₂, the third metal oxide includes TiO₂, and a thickness of the first interlayer may be smaller than that of the dielectric layer. Referring to FIG. 1, a dielectric layer is disposed between a first thin-film electrode layer and a second thin-film electrode layer, and an interlayer is disposed between the first thin-film electrode layer and the dielectric layer.

When a first interlayer including first metal oxide is disposed between one of the first thin-film electrode layer and the second thin-film electrode layer that includes second metal oxide having a conductive rutile crystal structure and including non-noble metal and a dielectric layer including third metal oxide having a dielectric rutile crystal structure, deterioration of the one of the first thin-film electrode layer and the second thin-film electrode layer may be mitigated or prevented during a capacitor manufacturing process. Accordingly, in such a capacitor including the electrode layer and the dielectric layer, leakage current may be reduced between the electrode layer and the dielectric layer.

By including the non-noble metal oxide in the thin-film electrode layer (e.g., at least one of the first thin-film electrode layer and the second thin-film electrode layer), volume change of the thin-film electrode layer due to reduction from the metal oxide included the thin-film electrode layer to metal may be suppressed during a manufacturing process of a device including the capacitor. Consequently, deterioration of the electrode layer may be mitigated or prevented during a manufacturing process of a device including the capacitor.

When the thickness of the first interlayer is smaller than that of the dielectric layer, deterioration of the thin-film electrode layer may be prevented without not substantially affecting dielectric permittivity of the capacitor. When the thickness of the first interlayer is greater than that of the dielectric layer, the interlayer functions as the dielectric layer so that the overall dielectric permittivity of the capacitor may decrease.

The capacitor may include, for example, multiple first thin-film electrodes that are spaced apart or multiple second thin-film electrode layers that are spaced apart. The capacitor may further include a bridge connecting the multiple first thin-film electrode layers that are spaced apart to each other or the multiple second thin-film electrode layers that are spaced apart to each other. When a bridge (or a support) physically connecting the multiple first thin-film electrode layers that are spaced apart to each other or the multiple second thin-film electrode layers that are spaced apart to each other is disposed between the multiple electrode layers, the structural stability of the multiple first thin-film electrode layers that are spaced apart or the multiple second thin-film electrode layers that are spaced apart may be improved. The bridge may, for example, mitigate or prevent the multiple first thin-film electrodes that are spaced apart or the multiple second thin-film electrode layers that are spaced apart from tilting or falling. The bridge may be, for example, dielectric.

The first interlayer may, for example, extend from one first thin-film electrode layer to another first thin-film electrode layer adjacent to the one first thin-film electrode layer through the bridge. The first interlayer may, for example, extend from one second thin-film electrode layer to another second thin-film electrode layer adjacent to the one second thin-film electrode layer through the bridge.

The first interlayer may be, for example, dielectric. For example, in manufacturing a capacitor including a conductive first interlayer, the first interlayer may be disposed on the lower electrode, and the bridge for electrically separating a lower electrode of a first structure and a lower electrode of a second structure lower electrode may be disposed. Then, the first interlayer disposed on the bridge may be removed. Meanwhile, in manufacturing a capacitor including a dielectric first interlayer, a step of removing a first interlayer from a bridge may be omitted. Consequently, a manufacturing process of the capacitor including the dielectric first interlayer is simplified compared to the manufacturing process of the capacitor including the conductive first interlayer.

A thickness of the first interlayer may be, for example, smaller than that of the electrode layer including the first metal oxide. When the thickness of the first interlayer is smaller than that of the first thin-film electrode layer and/or that of the second thin-film electrode layer, deterioration of the first thin-film electrode layer and/or the second thin-film electrode layer may be mitigated or prevented without substantially affecting the dielectric permittivity of the capacitor. When the thickness of the first interlayer is greater than that of the first thin-film electrode layer and/or the second thin-film electrode layer, the first interlayer may act as a dielectric layer so that the overall dielectric permittivity of the capacitor may be reduced.

The thickness of the first interlayer may be, for example, 1 Å to less than 20 Å, 1 Å to less than 15 Å, 1 Å to less than 10 Å, 3 Å to less than 10 Å, or 5 Å to less than 10 Å. When the thickness of the first interlayer is within the ranges above, the deterioration of the first thin-film electrode layer and/or the second thin-film electrode layer may be effectively mitigated or prevented without acting as the dielectric layer. Consequently, the leakage current of the capacitor may be further reduced.

The first interlayer may be a crystalline layer with a rutile crystal structure or an amorphous layer.

The first interlayer may be, for example, formed by epitaxial growth on the electrode layer having a rutile crystal structure, and thus may be a crystalline layer having a rutile crystal structure. Since the first interlayer is a crystalline layer having a rutile crystal structure, the dielectric layer having a rutile crystal structure may be more easily formed on the first interlayer. In addition, the first interlayer may be, for example, an amorphous layer. When the first interlayer is an amorphous layer, the first interlayer may be formed under low temperature conditions.

The first interlayer may include first metal oxide, the electrode layer may include second metal oxide, and the dielectric layer may include third metal oxide, wherein a chemical potential of the first metal oxide may be higher than that of the second metal oxide and that of the third metal oxide. When the chemical potential of the first metal oxide is higher than that of the second metal oxide, oxygen ions may be more easily transferred from the first interlayer to the dielectric layer compared to the transfer from the electrode layer to the dielectric layer. When the dielectric layer is directly deposited on the electrode layer, the second metal oxide may be easily reduced by the transfer of oxygen ions from the second metal oxide of the electrode layer to the third metal oxide of the dielectric layer. Meanwhile, when the first interlayer is additionally disposed on the electrode layer, the first metal oxide may be reduced by the transfer of oxygen ions from the first metal oxide of the first interlayer to the dielectric layer. However, the transfer of oxygen ions from the second metal oxide of the electrode layer to the dielectric layer may be suppressed, and thus the reduction of the second metal oxide may be suppressed. Consequently, because reduction of work function of the electrode layer including the second metal oxide by the reduction of the second metal oxide is mitigated or prevented, an increase in the leakage current between the electrode layer and the dielectric layer may be suppressed.

In addition, the chemical potential of the second metal oxide may be higher than that of the third metal oxide. Thus, the chemical potential of the first metal oxide may be higher than that of the second metal oxide, and the chemical potential of the second metal oxide may be higher than that of the third metal oxide.

The first interlayer may include the first metal oxide, and the first metal oxide may include first metal. The first metal may be, for example, a non-noble metal. The first metal may be, for example, metal other than noble metal among metals of Groups 3 to 16 of the periodic table of elements, and any metal capable of forming metal oxide having a higher chemical potential than that of the second metal oxide of the electrode layer may be used as the first metal. The first metal may be, for example, at least one selected from Ge, Mn, Sn, Cr, Nb, and W. When the first interlayer includes such first metal, the deterioration of the electrode layer during deposition of the dielectric layer may be further effectively mitigated or prevented.

The first interlayer may include, for example, defects. In the process of disposing the dielectric layer on the first interlayer, defects may be generated in the first interlayer by the transfer of oxygen ions disposed at an interface between the first interlayer and the dielectric layer and/or in the first interlayer. When a heat treatment process is included in the capacitor manufacturing process, defects may be generated in the first interlayer due to the heat treatment. An example of defects included by the first interlayer may be oxygen vacancy. The presence of defects may be, for example, confirmed by the presence of a sub-peak generated around a main peak in an XRD spectrum. For example, compared to a single crystal thin film having no defects, a crystalline thin film having defects may additionally include a sub-peak appearing around a main peak. The number of defects included in the first interlayer may be, for example, greater than that of defects included in the electrode layer. The number of oxygen vacancy included in the first interlayer may be, for example, greater than that of oxygen vacancy included in the electrode layer.

The first interlayer may include the first metal oxide, and the first metal oxide may be, for example, a binary metal oxide. The binary metal oxide may be an oxide including one type of a metal element and an oxygen element. The binary metal oxide may be doped by a dopant. The doped binary metal oxide may include one type of a metal element and an oxygen element.

The first metal oxide may be, for example, represented by Formula 1:

Formula 1 A1O_{2-δ1},

where 0<δ1<2, and A1 may be at least one selected from Ge, Mn, and Sn. In Formula 1, for example, 0.5<δ1<2, 1.0<δ1<2, 1.5<δ1<2, or 1.7<δ1<2.

The first metal oxide may include, for example, at least one selected from GeO₂, SnO₂, MnO₂, GeO₂₋ₐ (0<a<2), SnO₂₋ₐ (0<a<2), MnO₂₋ₐ (0<a<2), GeO₂₋ₐ (1<a<2), SnO₂₋ₐ (1<a<2), and MnO₂₋ₐ (1<a<2). When the first interlayer includes such first metal oxide, the leakage current between the electrode layer and the dielectric layer may be effectively mitigated or prevented.

Among the first thin-film electrode layer and the second thin-film electrode layer, the one that is in contact with the first interlayer or adjacent to the first interlayer may include the second metal oxide, and the second metal oxide may be, for example, represented by Formula 2:

Formula 2 A2₁₋ₓB2ₓO_{2-δ2},

where 0≤x≤0.5, 0<δ2<2, A2 may be a tetravalent atom, B2 may be a divalent atom, a trivalent atom, or a tetravalent atom, A2 may be non-noble metal, and B2 may be a dopant.

In Formula 2, for example, 0<x≤0.5, 0<x≤0.3, 0<x≤0.1, 0<x≤0.05, or 0<x≤0.01. In Formula 2, for example, 0.5<δ2<2, 1.0<δ2<2, 1.5<δ2<2, or 1.7<δ2<2.

In Formula 2, A2 may be, for example, at least one selected from Mo, Sn, Ge, Cr, W, and V. In Formula 2, B2 may be, for example, at least one selected from Ta, Nb, Sb, Mn, and Fe.

The second metal oxide may include, for example, at least one selected from MoO₂, SnO₂, Sn₁₋ₓTaₓO₂ (0.01≤x≤0.1), Sn₁₋ₓNbₓO₂ (0.01 ≤x≤0.1), Sn₁₋ₓSbₓO₂ (0.01≤x≤0.1), Sn₁₋ₓMnₓO₂ (0.01≤x≤0.1), and Sn₁₋ₓFeₓO₂ (0.01≤x≤0.1).

The dielectric layer may include the third metal oxide, and the third metal oxide may be, for example, represented by Formula :

Formula 3 Ti_{1-y}B3_{y}O_{2-δ3},

where 0≤y≤0.5, AND 0<δ3<2, and B3 may be a divalent atom, a trivalent atom, or a tetravalent atom.

In Formula 3, B3 may be, for example, at least one selected from Ga, Al, La, B, In, Sc, and Y. In Formula 3, for example, 0<y≤0.5, 0<y≤0.3, 0<y≤0.1, 0<y≤0.05, or 0<y≤0.01, and 0.5<δ3<2, 1.0<δ3<2, 1.5<δ3<2, or 1.7<δ3<2.

The third metal oxide may include, for example, at least one selected from TiO₂, Ti_{1-y}Ga_{y}O₂ (0.01≤y≤0.1), Ti_{1-y}Al_{y}O₂ (0.01≤y≤0.1), Ti_{1-y}La_{y}O₂ (0.01≤y≤0.1), Ti_{1-y}B_{y}O₂ (0.01≤y≤0.1), Ti_{1-y}In_{y}O₂ (0.01≤y≤0.1), Ti_{1-y}Sc_{y}O₂ (0.01 ≤y≤0.1), and Ti_{1-y}Y_{y}O₂ (0.01 ≤y≤0.1).

The capacitor may include a dielectric layer, and a thickness of the dielectric layer may be, for example, in a range of 2 nm to 100 nm, 5 nm to 100 nm, 5 nm to 50 nm, 5 nm to 30 nm, or 5 nm to 20 nm. When the thickness of the dielectric layer excessively increases, the capacity per unit volume of the capacitor may be reduced. When the thickness of the dielectric layer is excessively small, a proportion of a dielectric permittivity reduction region in the interface between the electrode layer and the dielectric layer may be increased, and thus the capacity per unit volume of the capacitor may be reduced.

The capacitor may include the first thin-film electrode layer and the second thin-film electrode layer, and the thickness of the first thin-film electrode layer and/or the second thin-film electrode layer may be, for example, in a range of 5 nm to 1,000 nm, 10 nm to 1,000 nm, 10 nm to 500 nm, or 10 nm to 100nm. When the thickness of the thin-film electrode layer excessively increases, the capacity per unit volume of the capacitor may be reduced. When the thickness of the thin-film electrode layer is excessively small and the thickness of the dielectric layer is excessively small, a proportion of the dielectric permittivity reduction region in the interface between the electrode layer and the dielectric layer may be increased, and thus the capacity per unit volume of the capacitor may be reduced.

At least one of the first thin-film electrode layer and the second thin-film electrode layer may not be in contact with the first interlayer, and the electrode layer that is not contact with the first interlayer may include at least one selected from metal, oxide of the metal, doped oxide of the metal, nitride, and carbide of the metal.

The metal included in the electrode layer that is not contact with the first interlayer may include at least one selected from Pt, Ti, W, Ta, Co, Mo, Ni, V, Hf, Al, Cu, Pd, Ir, Au, and Ru. The metal included in at least one of the first thin-film electrode layer and the second thin-film electrode layer is not limited to these metals, and any metal that is used for electrode layers in the art may be used.

The oxide of the metal include in the electrode layer that is not contact with the first interlayer may include, for example, at least one selected from MoO₂, VO₂, RuO₂, IrO₂, PtO₂, SnO₂, MnO₂, Sb₂O₃, and In₂O₃. The oxide of the metal included in at least one of the first thin-film electrode layer and the second thin-film electrode layer is not limited to these metals, and any oxide of metal that is used for electrode layers in the art may be used.

The doped oxide of the metal included in the electrode layer that is not contact with the first interlayer may include, for example, at least one selected from Ta-doped SnO₂, Sb-doped SnO₂, Ni-doped SnO₂, Ti-doped In₂O₃, Ni-doped SnO₂, Sb-doped SnO₂, and Al-doped ZnO. That is, the doped oxide of the metal included in at least one of the first thin-film electrode layer and the second thin-film electrode layer is not limited to these metals, and any doped oxide of the metal that is used for electrode layers in the art may be used. A type of the metal to be doped (e.g., a dopant), is not specifically limited, and any dopant that improves conductivity of an oxide of the metal may be used. The dopant may be, for example, metal.

The nitride of the metal included in the electrode layer that is not in contact with the first layer may include, for example, at least one selected from TiN, WN, TaN, TiAlN, TaSiN, TiSiN, WSiN, TiAlN, TiCN, TiAlCN, RuCN, and RuTiN. The nitride of the metal included in at least one of the first thin-film electrode layer and the second thin-film electrode layer is not limited to these metals, and any nitride of the metal that is used for electrode layers in the art may be used. The nitride of the metal may include a carbon-containing nitride of the metal.

At least one of the first thin-film electrode layer and the second thin-film electrode layer may have a multi-layer structure. For example, at least one thin-film electrode layer having a multi-layer structure may be constituted of a laminate of multiple sub-electrode layers. The number of sub-electrode layers constituting at least one thin-film electrode layer may be 2 to 10, 2 to 6, or 2 to 4, but is not necessarily limited thereto and may be appropriated selected within the ranges above.

At least one of the first thin-film electrode layer and the second thin-film electrode layer may additionally include a second layer that is disposed between the multiple sub-electrode layers constituting the thin-film electrode layer having the multi-layer structure. When the second interlayer additionally disposed between the multiple sub-electrode layers, deterioration of the first thin-film electrode layer and/or the second thin-film electrode layer may be further effectively mitigated or prevented. For example, multiple second interlayers may each be disposed between the multiple sub-electrode layers. When the capacitor additionally includes the second interlayer, leakage current may be further reduced.

A thickness of the second interlayer may be, for example, 1 Å to less than 20 Å, 1 Å to less than 15 Å, 1 Å to less than 10 Å, 3 Å to less than 10 Å, or 5 Å to less than 10 Å. When the thickness of the second interlayer is within the ranges above, deterioration of the first thin-film electrode layer and/or the second thin-film electrode layer may be further effectively mitigated or prevented without acting as the dielectric layer. Consequently, leakage current of the capacitor may be further reduced.

The second interlayer may have the same composition as the first interlayer. The second interlayer may include, for example, the first metal oxide. The second interlayer may include, for example, at least one selected from GeO₂, SnO₂, MnO₂, GeO₂₋ₐ (1<a<2), SnO₂₋ₐ (1<a<2), and MnO₂₋ₐ (1<a<2).

A type of the capacitor is not specifically limited. The capacitor may be, for example, a capacitor device used in memory cells, a stacked capacitor used in stacked ceramic condensers, or the like.

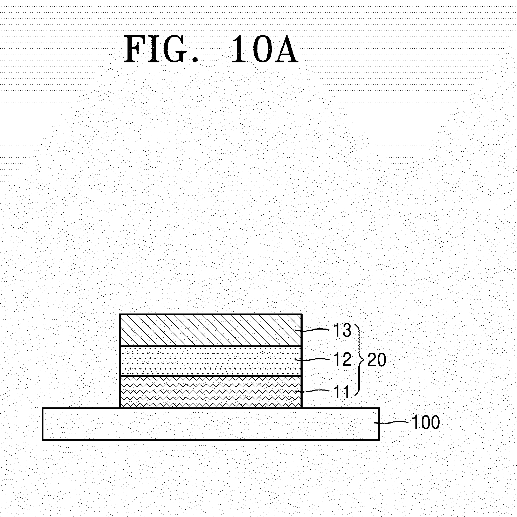

FIGS. 10A to 10D are each a schematic view of a capacitor 20 according to an example embodiment.

FIG. 10A shows an example of a structure of a capacitor 20 including the aforementioned first interlayer (not shown). In this structure, the capacitor 20 includes a dielectric substrate 100, a pair of electrodes (e.g., a first thin-film electrode 11 and a second thin-film electrode 13), a dielectric layer 12, and an interlayer (not shown). The first thin-film electrode 11 and the second thin-film electrode 13 function as a lower thin-film electrode and an upper thin-film electrode, respectively. The first thin-film electrode 11 and the second thin-film electrode 13 may not be electrically connected to each other, and the dielectric layer 12 may be disposed between the first thin-film electrode 11 and the second thin-film electrode 13. The first interlayer (not shown) may be disposed between the first thin-film electrode 11 and the dielectric layer 12 and/or between the second thin-film electrode 13 and the dielectric layer 12.

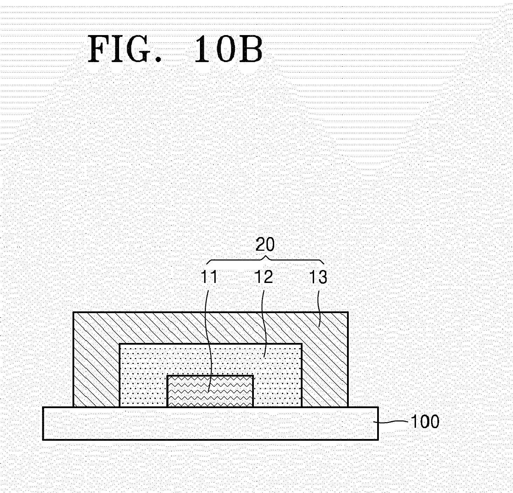

FIGS. 10B to 10D show other examples of structures of the capacitor 20, each including the aforementioned first interlayer (not shown).

Referring to FIG. 10B, the dielectric layer 12 is disposed so as to coat the first thin-film electrode 11 on the dielectric substrate 100, and the second thin-film electrode 13 is disposed so as to coat the dielectric layer 12. The first interlayer (not shown) is disposed between the first thin-film electrode 11 and the dielectric layer 12 and/or between the second thin-film electrode 13 and the dielectric layer 12. A thickness of the first interlayer (not shown) may be smaller than that of the dielectric layer 12. The first interlayer (not shown) may include more defects than the contacting first thin-film electrode 11 and/or the contacting second thin-film electrode 13.

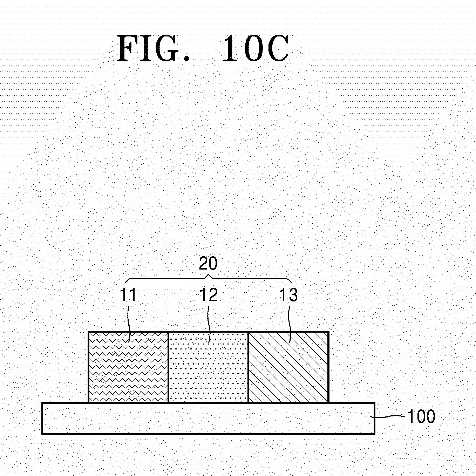

Referring to FIG. 10C, the first thin-film electrode 11 and the second thin-film electrode 13 are disposed on the dielectric substrate 100, and the dielectric layer 12 is disposed therebetween. The first interlayer (not shown) is disposed between the first thin-film electrode 11 and the dielectric layer 12 and/or between the second thin-film electrode 13 and the dielectric layer 12. The first interlayer (not shown) may include more defects than the contacting first thin-film electrode 11 and/or the contacting second thin-film electrode 13.

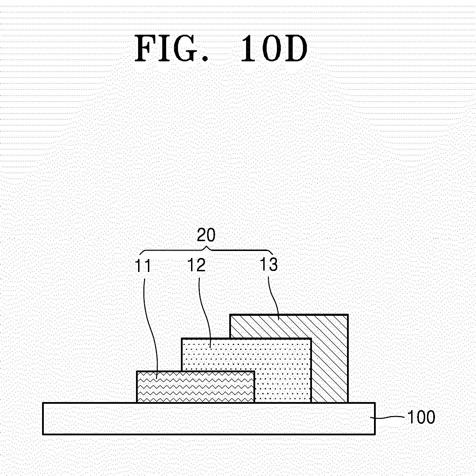

Referring to FIG. 10D, the dielectric layer 12 is disposed so as to coat a portion of the first thin-film electrode 11 on the dielectric substrate 100, and the second thin-film electrode 13 is disposed so as to coat a portion of the dielectric layer 12. The interlayer (not shown) is disposed between the first thin-film electrode 11 and the dielectric layer 12 and/or between the second thin-film electrode 13 and the dielectric layer 12. The first interlayer (not shown) may include more defects than the contacting first thin-film electrode 11 and/or the contacting second thin-film electrode 13.

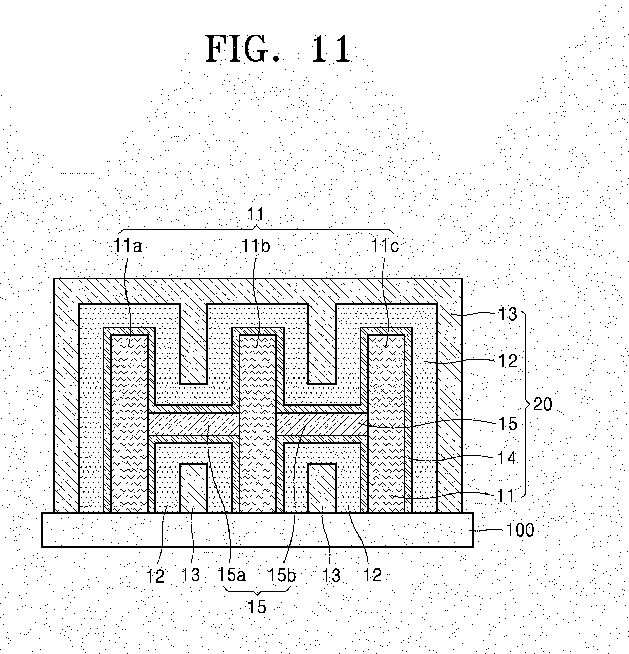

FIG. 11 is a schematic view of the capacitor 20 according to another example embodiment.

In FIG. 11, multiple first thin-film electrodes 11, 11a, 11b, and 11c are spaced apart from each other on the dielectric substrate 100, and bridges 15, 15a, and 15b) physically connect the multiple first thin-film electrodes 11, 11a, 11b, and 11c. When the bridges 15, 15a, and 15b connect the multiple first thin-film electrodes 11, 11a, 11b, and 11c each other, the first thin-film electrodes 11, 11a, 11b, and 11c may be mitigated or prevented from tilting or falling. A first interlayer 14 is disposed on the first thin-film electrodes 11, 11a, 11b, and 11c and the bridges 15, 15a, and 15b. The first interlayer 14 may extend, for example, from one first thin-film electrode 11a to another adjacent first thin-film electrode 11b via the bridge 15a. The dielectric layer 12 is disposed on the first interlayer 14. The second thin-film electrode 13 is disposed to coat the dielectric layer 12.

The aforementioned capacitor may be employed in various electronic devices. The aforementioned capacitor may be utilized as a dynamic random access memory (DRAM) device together with a transistor. In addition, together with other circuit elements, the aforementioned capacitor may constitute an electronic circuit constituting an electronic device.

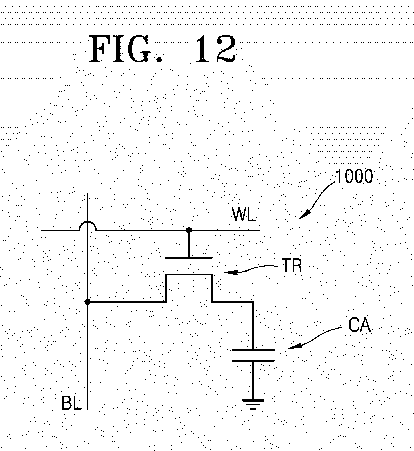

FIG. 12 is a circuit diagram illustrating a schematic circuit configuration and operation of an electronic device employing the capacitor according to an example embodiment.

The circuit diagram of an electronic device 1000 is for a single cell of the DRAM device, and includes a single transistor (TR), a single capacitor (CA), a wordline (WL), and a bitline (BL). The capacitor CA may be the capacitor described in FIGS. 1 and FIG. 10A to 10D.

The data writing operation of the DRAM is as follows. After a gate voltage (high) is applied to a gate electrode through the wordline WL to turn "on" the transistor TR, a voltage, VDD (high) or 0 (low), which is a voltage value of data to be input on the bitline BL is applied. When a high voltage is applied to the wordline WL and the bitline BL, the capacitor CA is charged and data "1" is recorded. When a high voltage is applied to the wordline WL and a low voltage is applied to the bitline BL, the capacitor CA is discharged and date "0" is recorded.

For the data reading operation, a high voltage is applied to the wordline WL to turn on the transistor TR of the DRAM, and then a voltage of VDD/2 is applied to the bitline BL. When data written in the DRAM is "1" (e.g., in a case where a voltage of the capacitor CA is VDD), a voltage of the bitline BL becomes slightly higher than VDD/2 as charges transfer from the capacitor CA to the bitline BL. Meanwhile, when data written in the capacitor CA is "0", a voltage of the bitline BL becomes slightly lower than VDD/2 as charges transfer from the bitline BL to the capacitor CA. Then, when a potential difference thus generated in the bitline BL is sensed by a sense amplifier and is amplified, the corresponding data can be determined as '0' or '1'.

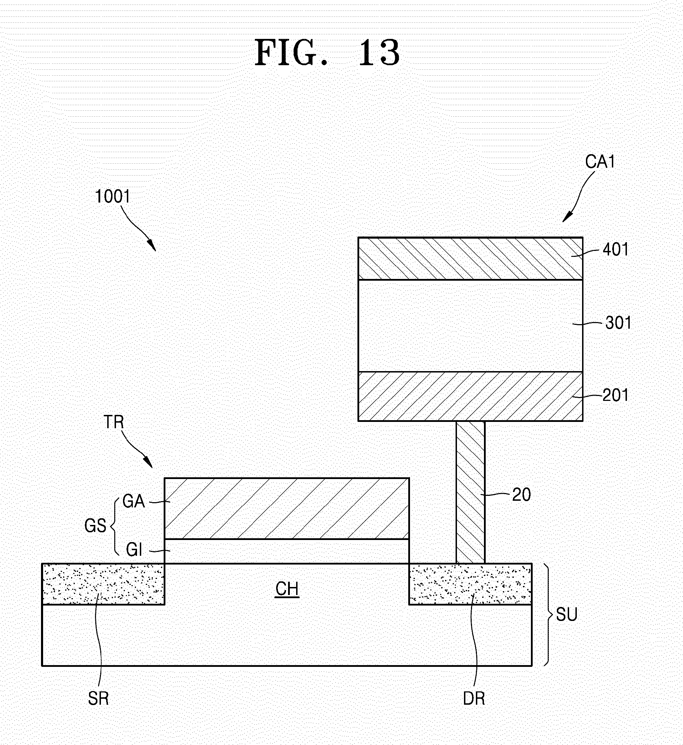

FIG. 13 is a schematic view of an electronic device according to an example embodiment.

Referring to FIG. 13, in an electronic device 1001, a capacitor CA1 and a transistor TR may be electrically connected to each other through a contact 20. The capacitor CA1 includes a lower electrode 201, an upper electrode 401, and a dielectric thin film 301 disposed therebetween. The capacitor CA1 may be the same capacitor as described in one of FIG. 1, FIG. 10A to 10 D, and FIG. 11, and thus a description thereof will be omitted.

The transistor TR may be a field effect transistor. The transistor TR may include a semiconductor substrate SU including a source region SR, a drain region DR, and a channel region CH; and a gate stack GS including a gate insulating layer GI and a gate electrode GA that are disposed to face the channel region CH on the semiconductor substrate SU.

The channel region CH is a region between the source region SR and the drain region DR, and is electrically connected to the source region SR and the drain region DR. The source region SR may be electrically connected to or in contact with one end of the channel region CH, and the drain region DR may be electrically connected to or in contact with the other end of the channel region CH. The channel region CH may be defined as a substrate region between the source region SR and the drain region DR of the semiconductor substrate SU.

The semiconductor substrate SU may include a semiconductor material. The semiconductor substrate SU may include, for example, a semiconductor material such as silicon (Si), germanium (Ge), silicon germanium (SiGe), silicon carbide (SiC), gallium arsenic (GaAs), indium arsenic (InAs), or indium phosphide (InP). In addition, the semiconductor substrate SU may include a silicon on insulator (SOI) substrate.

The source region SR, the drain region DR, and the channel region CH may each independently be formed by injecting impurities into different regions of the semiconductor substrate SU. In this case, the source region SR, the channel region CH, and the drain region DR may each include a substrate material as a base material. The source region SR and the drain region DR may each be formed of a conductive material. In this case, the source region SR and the drain region DR may each include, for example, metal, metal compound, or conductive polymer.

Unlike the drawing, the channel region CH may be implemented as a separate material layer (thin film). In this case, the channel region CH may include, for example, at least one of Si, Ge, SiGe, a Group III-V semiconductor, an oxide semiconductor, a nitride semiconductor, an oxynitride semiconductor, a two-dimensional (2D) material, a quantum dot, and an organic semiconductor. The oxide semiconductor may include, for example, InGaZnO. The 2D material may include, for example, transition metal dichalcogenide (TMD) or graphene. The quantum may include, for example, a colloidal quantum dot or a nanocrystal structure.

The gate electrode GA may be disposed on the semiconductor substrate SU to be spaced apart from the semiconductor substrate SU and face the channel region CH. The gate electrode GA may include at least one of metal, metal nitride, metal carbide, and polysilicon. The metal may include, for example, at least one of aluminum (Al), tungsten (W), molybdenum (Mo), titanium (Ti), and tantalum (Ta). The metal nitride film may include, for example, at least one of a Ti nitride (TiN) film and a Ta nitride (TaN) film. The metal carbide may include, for example, at least one metal carbide doped (or containing) with Al and Si. The metal carbide may include, for example, TiAlC, TaAlC, TiSiC, or TaSiC.

The gate electrode GA may have a structure in which multiple materials are stacked. The gate electrode GA may have, for example, a stacked structure of metal nitride layer/metal layer, such as TiN/Al, or a stacked structure of metal nitride layer/metal carbide layer/metal layer, such as TiN/TiAlC/W. The aforementioned materials used for the gate electrode GA are merely examples, and are not limited thereto.

The gate insulating layer GI may be further disposed between the semiconductor substrate SU and the gate electrode GA. The gate insulating layer GI may include a paraelectric material or a high-k dielectric material. The gate insulating layer GI may have, for example, dielectric permittivity of 20 to 70.

The gate insulating layer GI may include, for example, silicon oxide, silicon nitride, aluminum oxide, hafnium oxide, or zirconium oxide, or a 2D insulator such as hexagonal boron nitride (h-BN). The gate insulating layer GI may include, for example, silicon oxide (SiO₂), silicon nitride (SiNx), hafnium oxide (HfO₂), hafnium silicon oxide (HfSiO₄), lanthanum oxide (La₂O₃), lanthanum aluminum oxide(LaAlO₃), zirconium oxide (ZrO₂), hafnium zirconium oxide(HfZrO₂), zirconium silicon oxide (ZrSiO₄), tantalum oxide(Ta₂O₅), titanium oxide (TiO₂), strontium titanium oxide(SrTiO₃), yttrium oxide(Y₂O₃), aluminum oxide(Al₂O₃), red scandium tantalum oxide (PbSc_{0.5}Ta_{0.5}O₃), or red zinc niobate (PbZnNbO₃). The gate insulating layer GI may include, for example, metal nitride oxide such as aluminum oxynitride (AlON), zirconium oxynitride (ZrON), hafnium oxynitride (HfON), lantanium oxynitride (LaON), or yttrium oxynitride (YON), silicate such as ZrSiON, HfSiON, YSiON, or LaSiON, or aluminate such as ZrAlON and HfAlON. The gate insulating layer GI may include, for example, the dielectric layer of the aforementioned capacitor. The gate insulating layer GI may constituted a gate stack together with the gate electrode GA.

One of the electrodes 201 and 401 of the capacitor CA1 may be electrically connected to one of the source region SR and the drain region DR of the transistor TR through the contact 20. The contact 20 may include a suitable conductive material, such as tungsten, copper, aluminum, polysilicon, and the like.

The dispose of the capacitor CA1 and the transistor TR may be variously modified. For example, the capacitor CA1 may have a structure disposed on the semiconductor substrate SU or a structure embedded in the semiconductor substrate SU.

FIG. 13 shows the electronic device 1001 including one capacitor CA1 and one transistor TR, but is only an embodiment. The electronic device 1001 may include multiple capacitors and multiple transistors.

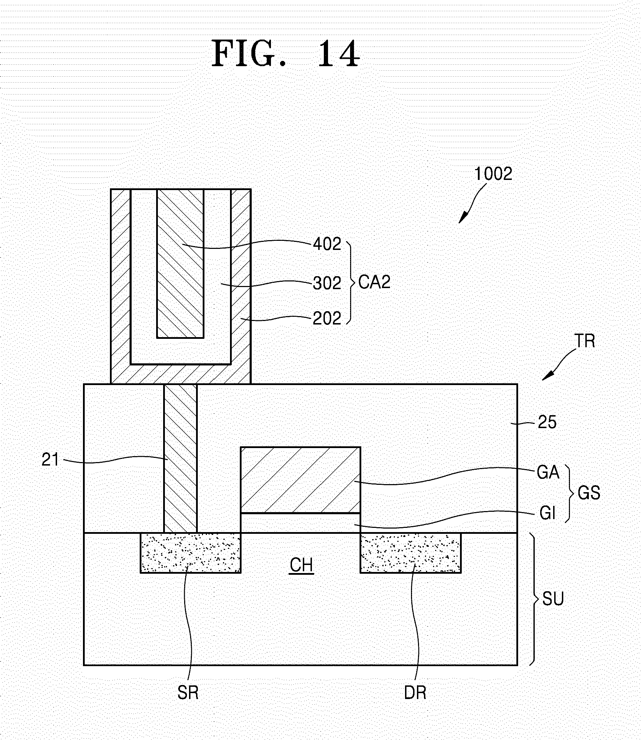

FIG. 14 shows an electronic device according to another example embodiment.

Referring to FIG. 14, an electronic device 1002 may have a structure in which a capacitor CA2 and a transistor TR are electrically connected to each other through a contact 20.

The transistor TR may include a semiconductor substrate SU including a source region SR, a drain region DR, and a channel region CH; and a gate stack GS including a gate insulating layer GI and a gate electrode GA that are disposed to face the channel region CH on the semiconductor substrate SU.

An inter-insulating layer 25 may be provided on the semiconductor substrate SU to cover the gate stack GS. The inter-insulating layer 25 may include a dielectric material. The inter-insulating layer 25 may include, for example, Si oxide (e.g., SiO₂), Al oxide (e.g., Al₂O₃), or a high-k dielectric material (e.g., HfO₂). The contact 21 passes through the inter-insulating layer 25 to electrically connect the transistor TR and the capacitor CA2 to each other.

The capacitor CA2 includes a lower electrode 202, an upper electrode 4012 and a dielectric thin film 302 disposed therebetween. The lower electrode 110 and the upper electrode 402 may be provided in a shape that can maximize a contact area with the dielectric thin film 302, and a material for forming the capacitor CA2 may be the substantially the same as a material for forming the aforementioned capacitors of FIGS. 1, 10Ato 10D, and 11.

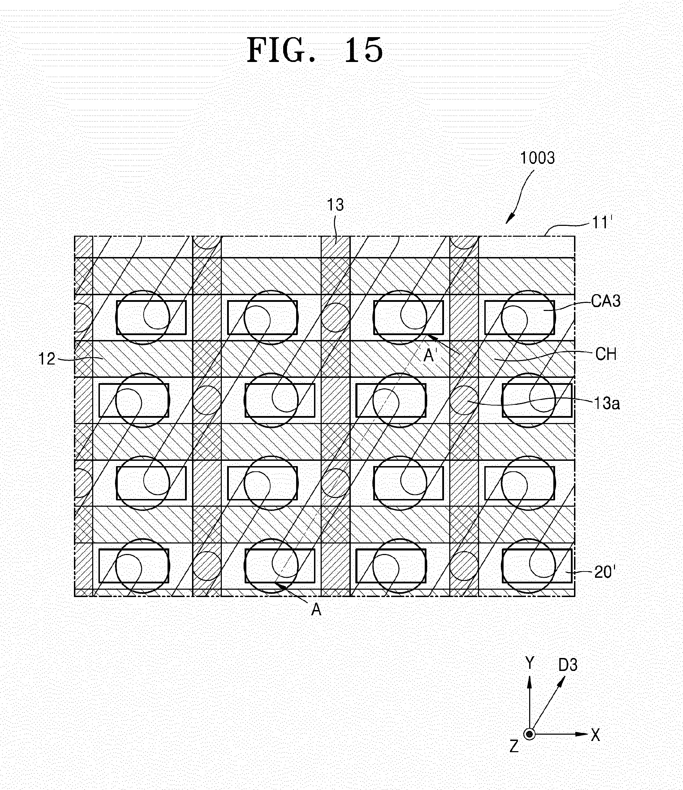

FIG. 15 is a plan view of an electronic device according to another example embodiment.

Referring to FIG. 15, an electronic device 1003 may have a structure in which multiple capacitors and multiple field effect transistors are repeatedly disposed. The electronic device 1003 may further include a field effect transistor including a semiconductor substrate 11', which includes a source, a drain, and a channel, , a gate stack GA 12, a contact structure 20' disposed on the semiconductor substrate 11' so as not to overlap with the gate stack 12, a capacitor CA3 disposed on the contact structure 20', and a bitline structure 13 electrically connecting multiple field effect transistors together.

FIG. 15 shows an example embodiment of a form (e.g., arrangement or layout) in which both the contact structure 20' and the capacitor CA3 are repeatedly disposed along the X and Y directions, but the form is not limited thereto. The contact structure 20' may be, for example, disposed along the X and Y directions, and the capacitor CA3 may be disposed in a hexagonal shape such as a honeycomb structure. In some example embodiments, the capacitor CA3 may have, for example, a circular shape, a triangular shape, a quadrangular shape, or a pentagonal shape. In some example embodiments, the capacitor CA3 may have, for example, a cylinder shape, a triangular prism shape, a quadrangular prism shape, or a pentagonal prism shape. The quadrangular prism shape may have, for example, a cube shape or a cuboid (sheet) shape.

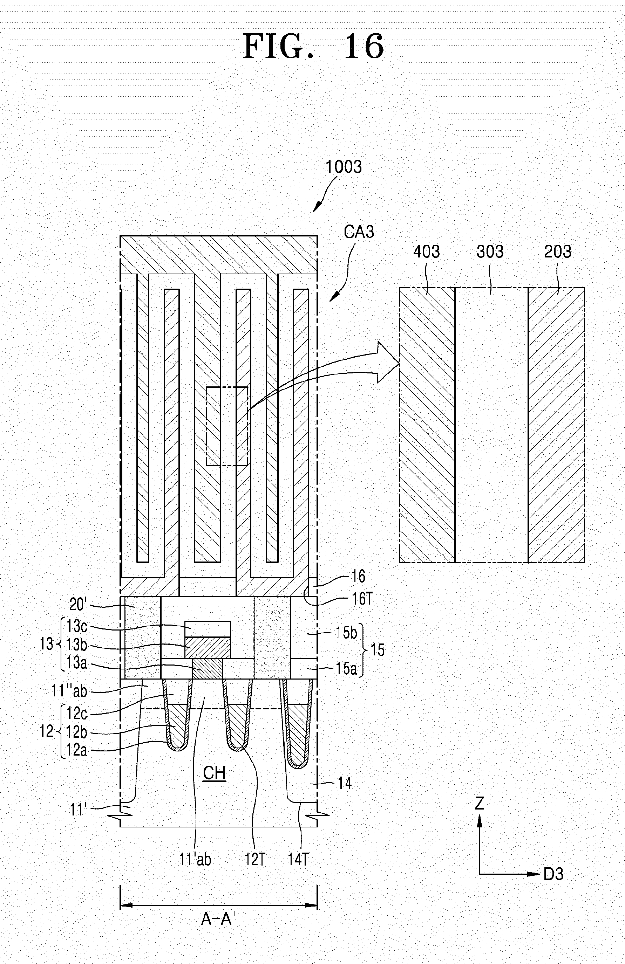

FIG. 16 is a cross-sectional view taken along line A-A' of FIG. 15.

Referring to FIG. 16, the semiconductor substrate 11' may have a shallow trench isolation (STI) structure including a device separation membrane 14. The device separation membrane 14 may be a single layer formed of one type of an dielectric film, or a multi-layer formed of a combination of two or more dielectric films. The device separation membrane 14 may include a device separation trench 14T in the semiconductor substrate 11', and the device separation trench 14T may be filled with a dielectric material. The dielectric material may include at least one of fluoride silicate glass (FSG), undoped silicate glass (USG), boro-phospho-silicate glass (BPSG), phospho-silicate glass (PSG), flowable oxide (FOX), plasma enhanced tetraethyl-ortho-silicate (PE-TEOS), and tonen silazene (TOSZ), but is not limited thereto.

The semiconductor substrate 11' may further include a channel region CH defined by the device separation membrane 14, and a gate line trench 12T disposed to be parallel to an upper surface of the semiconductor substrate 11' and extend in the X direction. The channel region CH may have a relatively long island shape having short and long axes. As shown in FIG. 15, the long axis of the channel region CH may be disposed along a direction D3 parallel to the upper surface of the semiconductor substrate 11'.

The gate line trench 12T may be disposed to cross the channel region CH at a predetermined depth from the upper surface of the semiconductor substrate 11', or may be disposed in the channel region CH. The gate line trench 12T may also be disposed inside the device separation trench 14T, and a bottom surface of the gate line trench 12 inside the device separation trench 14T may be lower than that of the gate line trench 12T of the channel region CH. A first source/drain 11'ab and a second source/drain 11"ab may be disposed on an upper portion of the channel region CH positioned on both sides of the gate line trench 12T.

The gate stack 12 may be disposed inside the gate line trench 12T. For example, a gate insulating layer 12a, a gate electrode 12b, and a gate capping layer 12c may be sequentially disposed inside the gate line trench 12T. The gate insulating layer 12a and the gate electrode 12b may be understood by referring to the descriptions above, and the gate capping layer 12c may include at least one of silicon oxide, silicon oxynitride, and silicon nitride. The gate capping layer 12c may be disposed on the gate electrode GA to fill the remaining portion of the gate line trench 12T.

A bitline structure 13 may be disposed on the first source/drain 11'ab. The bitline structure 13 may be disposed to be parallel to the upper surface of the semiconductor substrate 11' and to extend along the Y direction. The bitline structure 13 may be electrically connected with the first source/drain 1 1'ab, and a substrate may include a bitline contact 13a, a bitline 13b, and a bitline capping layer 13c that are sequentially stacked. The bitline contact 13a may include, for example, polysilicon. The bitline 13b may include, for example, a metal material. The bitline capping layer 13c may include, for example, an insulating material such as silicon nitride or silicon oxynitride.

FIG. 16 shows a case where a bottom surface of the bitline contact 13a is at the same level as the upper surface of the semiconductor substrate 11', but is only an example embodiment and example embodiments of the present inventive concepts are not limited thereto. For example, in one or more example embodiments, a recess formed to a predetermined depth from the upper surface of the semiconductor substrate 11' may be further provided, and the bitline contact 13a may extend into the recess. Thus, a bottom surface of the bitline contact 13a may be formed lower than the upper surface of the semiconductor substrate 11'.

The bitline structure 13 may further include a bitline interlayer (not shown) between the bitline contact 13a and the bitline 13b. The bitline interlayer may include, for example, metal silicide such as tungsten silicide, or metal nitride such as tungsten nitride. A bitline spacer (not shown) may be further formed on a sidewall of the bitline structure 13. The bitline spacer may have a single-layer structure or a multi-layer structure. The bitline spacer may include, for example, an insulating material, such as silicon oxide, silicon oxynitride, or silicon nitride. The bitline spacer may further include, for example, an air space (not shown).

The contact structure 20' may be disposed on the second source/drain 11"ab. The contact structure 20' and the bitline structure 13 may be disposed on different sources/drains on the substrate, respectively. The contact structure 20' may have a structure in which a lower contact pattern (not shown), a metal silicide layer (not shown), and an upper contact pattern (not shown) are sequentially stacked on the second source/drain 11"ab. The contact structure 20' may further include a barrier layer (not shown) surrounding side surfaces and a bottom surface of the upper contact pattern. The lower contact pattern may include, for example, polysilicon. The upper contact pattern may include, for example, a metal material. The barrier layer may include, for example, metal nitride having conductivity.

The capacitor CA3 may be electrically connected with the contact structure 20' to be disposed on the semiconductor substrate 11'. For example, the capacitor CA3 may include a lower electrode 203 electrically connected with the contact structure 20', an upper electrode 403 spaced apart from the lower electrode 203, and a dielectric thin film 303 disposed therebetween. The lower electrode 203 may have a cylindrical shape or a cup shape with an inner space closed at the bottom. The upper electrode 403 may have a comb shape with comb teeth extending into the inner space formed by the lower electrode 203 and a region between the adjacent lower electrodes 203. The dielectric thin film 303 may be disposed between the lower electrode 203 and the upper electrode 403 to be parallel to surfaces thereof.

Materials for forming the lower electrode 203, the dielectric thin film 303, and the upper electrode 403 that constitute the capacitor CA3 are substantially the same as the material for forming the capacitor described in FIGS. 1, 10A to 10D, and 11, and thus a description thereof will be omitted.

An inter-insulating layer 15 may be further disposed between the capacitor CA3 and the semiconductor substrate 11'. The inter-insulating layer 15 may be disposed in a space where no other structure is disposed between the capacitor CA3 and the semiconductor substrate 11'. For example, the inter-insulating layer 15 may be disposed to cover the wiring and/or electrode structure of the bitline structure 13, the contact structure 20', the gate stack 12, and the like on the substrate. For example, the inter-insulating layer 15 may surround walls of the contact structure 20'. The inter-insulating layer 15 may include a first inter-insulating layer 15a surrounding the bitline contact 13a and a second inter-insulating layer 15b covering side surfaces and/or upper surfaces of a bitline 13b and a bitline capping layer 13c.

The lower electrode 203 of the capacitor CA3 may be disposed on the inter-insulating layer 15, more particularly, on the second inter-insulating layer 15b. When multiple capacitors CA3 are disposed, bottom surfaces of multiple lower electrodes 203 may be separated by an etch-stop layer 16. In other words, the etch-stop layer 16 may include an opening 16T, and the bottom surface of the lower electrode 203 of the capacitor CA3 may be disposed in the opening 16T. The lower electrode 203 may have, as illustrated in the drawing, a cylindrical shape or a cup shape with an inner space closed at the bottom. The capacitor CA3 may further include a support (not shown) that mitigates or prevents the lower electrode 203 from tilting or falling, and such a support may be disposed on a sidewall of the lower electrode 203.

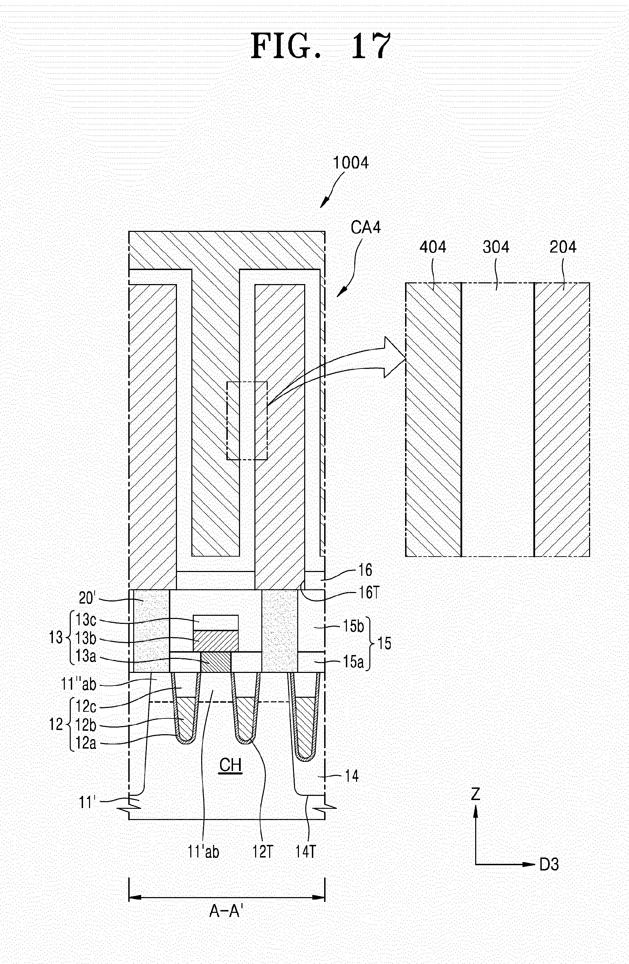

FIG. 17 is a cross-sectional view of an electronic device according to another example embodiment.

An electronic device 1004 of this example embodiment is shown in a cross-sectional view corresponding to the cross-sectional view taken along line A-A' of FIG. 15, and differs from the electronic device of FIG. 16 only in the shape of a capacitor CA4. The capacitor CA4 is electrically connected with the contact structure 20' to be disposed on the semiconductor substrate 11', and includes a lower electrode 204 that is electrically connected with the contact structure 20', an upper electrode 404 that is spaced apart from the lower electrode 204, and a dielectric thin film that is disposed between the lower electrode 204 and the upper electrode 404. Materials for forming the lower electrode 204, the dielectric thin film 304, and the upper electrode 404 are substantially the same as those for forming the capacitor described in FIGS. 1, 10A to 10D, and 11.

The lower electrode 204 may have a pillar shape, such as a cylinder, a quadrangular pillar, or a polygonal column, that extends in a vertical direction (Z-direction). The upper electrode 404 may have a comb shape with comb teeth extending into a region between the adjacent lower electrodes 204. The dielectric thin film 304 may be disposed between the lower electrode 204 and the upper electrode 404 to be parallel to surfaces thereof.

The capacitors and the electronic devices according to the example embodiments above may be applied to various application fields. For example, the electronic device according to the example embodiments may be applied as a logic device or a memory device. The electronic device according to the example embodiments may be used for arithmetic operation, program execution, temporary data retention, and the like in devices such as mobile devices, computers, laptops, sensors, network devices, neuromorphic device, and the like. In addition, the electronic elements and the electronic devices according to the example embodiments may be useful for an apparatus in which a data transmission quantity is large and data transmission is continuously performed.

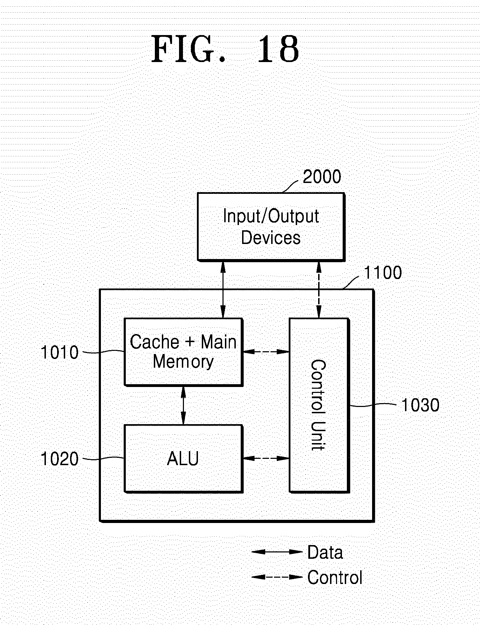

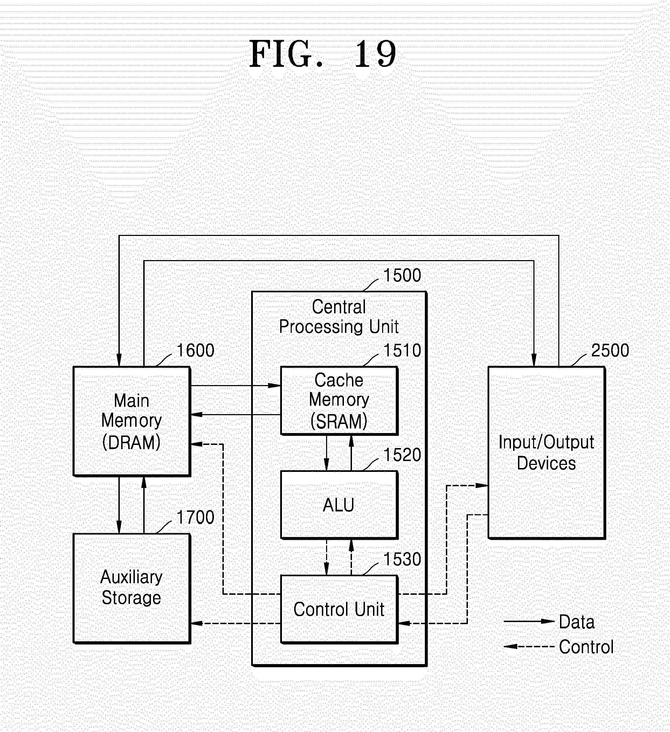

FIGS. 18 and 19 are each a conceptual diagram schematically showing a device architecture that is applicable to a device according to an example embodiment.

Referring to FIG. 18, the electronic device architecture 1100 may include a memory unit 1010, an arithmetic logic unit (ALU) 1020, and a control unit 1030. The memory unit 1010, the ALU 1020, and the control unit 1030 may be electrically connected to each other. The electronic device architecture 1100 may be, for example, implemented as a single chip including the memory unit 1010, the ALU 1020, and the control unit 1030.

The memory unit 1010, the ALU 1020, and the control unit 1030 may be connected to each other through on-chip metal lines for direct communication. The memory unit 1010, the ALU 1020, and the control unit 1030 may be monolithically integrated on one substrate to form one chip. The electronic device architecture (e.g., a chip) 1100 may be connected with an input/output device 2000. The memory unit 1010 may include both a main memory and a cache memory. The electronic device architecture (e.g., a chip) 1000 may be an on-chip memory processing unit. The memory unit (or memory cell) 1010 may include the aforementioned capacitor and an electronic device utilizing the same. The ALU 1020 or the control unit 1030 may each include the aforementioned capacitor. The control unit 1030 may be interchangeably referred to as a processor or processing circuitry.

Referring to FIG. 19, a cache memory 1510, an ALU 1520, and a control unit 1530 may constitute a central processing unit(CPU) 1500, and the cache memory 1510 may include a static random access memory (SRAM). Thus, the control unit 1530 may be interchangeably referred to as a processor or processing circuitry. Separately from the CPU 1500, a main memory 1600 and a secondary storage (e.g., auxiliary storage) 1700 may be provided. The main memory 1600 may be a dynamic random access memory (DRAM), and may include the aforementioned capacitor. Such an electronic device architecture may be implemented in a form in which computing unit devices and memory unit devices are adjacent to each other in a single chip without distinction of sub-units.

Although some example embodiments have been described above, these are merely examples, and various modifications will be made therefrom by those skilled in the art.

The aforementioned capacitors and the electronic devices including the same have been described with reference to the example embodiments shown in the drawings, but these are merely examples, and those skilled in the art will understand that various modifications and equivalent other example embodiments can be made therefrom. Therefore, the example embodiments disclosed herein are to be considered in an descriptive point of view rather than a restrictive point of view. The scope of the present specification is indicated in the claims rather than the above description, and all differences within the scope equivalent thereto should be construed as being included in the disclosure.

Another aspect of the disclosure provides a method of preparing the capacitor. The method may include providing one of a first thin-film electrode layer or a second thin-film electrode layer, first-disposing an interlayer on one surface of the provided one of the first thin-film electrode layer and the second thin-film electrode layer by epitaxy growth, second-disposing a dielectric layer on the interlayer by epitaxy growth, and third-disposing the other one of the first thin-film electrode layer and the second thin-film electrode layer on the dielectric layer to provide a capacitor, which includes the first thin-film electrode layer, the second thin-film electrode layer, the dielectric layer disposed between the first thin-film electrode layer and the second thin-film electrode layer. The interlayer includes first metal oxide, at least one of the first thin-film electrode layer and the second thin-film electrode layer includes second metal oxide having a conductive rutile crystal structure, the second metal oxide includes non-noble metal, the dielectric layer includes third metal oxide having a dielectric rutile crystal structure, the first metal oxide, the second metal oxide, and the third metal oxide have different compositions from each other, the first metal oxide includes GeO₂, the third metal oxide includes TiO₂, and a thickness of the first interlayer is smaller than that of the dielectric layer. When the capacitor manufactured by the aforementioned method includes the interlayer, the leakage current of the capacitor may be reduced, and the deterioration of the thin-film electrode layer may be suppressed during the manufacturing process of the capacitor.

The providing at least one of the first thin-film electrode layer and the second thin-film electrode layer and disposing the first interlayer on one surface of the provided at least one of the first thin-film electrode layer and the second thin-film electrode layer by epitaxy growth may include, for example, providing multiple first thin-film electrode layers that are spaced apart or multiple second thin-film electrode layers that are spaced apart, disposing a bridge at least one of between the multiple first thin-film electrode layers to connect the multiple first thin-film electrode layers to each other and between the multiple second thin-film electrode layers to connect the multiple second thin-film electrode layers to each other, and disposing a first interlayer simultaneously on one surface of the multiple first thin-film electrode layers or the multiple second thin-film electrode layers and on the bridge disposed between the multiple first thin-film electrode layers or between the multiple second thin-film electrode layers .

Referring to FIGS. 10A to 10D, the first thin-film electrode 11 or the second thin-film electrode 13 may be provided first.

The first thin-film electrode 11 and/or the second thin-film electrode 13 may include, for example, metal oxide selected from molybdenum oxide (MoO₂), tin oxide (SnO₂), Ta-doped tin oxide (Sn₁₋ₓTaₓO₂, 0.01≤x≤0.1), Nb-doped tin oxide (Sn₁₋ₓNbₓO₂, 0.01≤x≤0.1), Sb-doped tin oxide (Sn₁₋ₓSbₓO₂, 0.01≤x≤0.1), Mn-doped tin oxide (Sn₁₋ₓMnₓO₂, 0.01≤x≤0.1), and Fe-doped tin oxide (Sn₁₋ₓFeₓO₂, 0.01≤x≤0.1). The first thin-film electrode 11 and/or the second thin-film electrode 13 may each include metal oxide having a rutile crystal structure. The first thin-film electrode 11 and/or the second thin-film electrode 13 may be molybdenum oxide (MoO₂).

The first thin-film electrode 11 and/or the second thin-film electrode 13 may be formed by depositing metal oxide using an electron-beam epitaxy process, a liquid-phase epitaxy process, a vapor-phase epitaxy process, a chemical vapor deposition process, a sputtering process, an atomic layer deposition process, a pulsed laser deposition process, or the like. The first thin-film electrode 11 and the second thin-film electrode 13 may each have a single-layer structure or a multi-layer structure.

When the first thin-film electrode 11 is formed by using a pulsed laser deposition epitaxy process, for example, after loading a dielectric substrate 100 into a reaction chamber, the dielectric substrate 100 may be maintained at a temperature in a range of about 400 °C to about 800 °C, and a partial pressure of an oxidizing agent, such as oxygen-partial pressure, in the chamber may be maintained at a pressure in a range of 0.01 mbar to 1 mbar. By vaporizing metals and/or metal ions from a metal precursor, gaseous metals and/or gaseous metal ions constituting the first thin-film electrode 11 may be supplied. Subsequently, the gaseous metals and/or gaseous metal ions may be introduced onto the dielectric substrate 100, and an oxidizing agent may be supplied to form the first thin-film electrode 11. When the first thin-film electrode 11 includes an MoO₂ layer, the metal precursor may include, consist of or consist essentially of molybdenum or a first precursor compound including molybdenum, and the oxidizing agent may include oxygen (O₂), ozone (O₃), nitrogen dioxide (NO₂), or dinitrogen dioxide (N₂O). The oxidizing agent may be, for example, oxygen. The second thin-film electrode 12 may be formed in the same manner.

Although not shown in the drawing, the multiple first thin-film electrodes 11 may be, for example, spaced apart from each other on the dielectric substrate 100. Each of the multiple first thin-film electrodes 11 that are spaced apart from each other on the dielectric substrate 100 may have, for example, a shape protruding from the surface of the dielectric substrate 100, such as a cylinder shape or a cup shape. In addition, the bridge (not shown), which physically connects the multiple first thin-film electrodes 11 to each other, may be disposed between the multiple first thin-film electrodes 11. When the bridge (not shown) physically connecting the multiple first thin-film electrodes 11 is disposed therebetween, the multiple first thin-film electrodes 11 may be mitigated or prevented from tilting or falling.

The bridge may be a dielectric layer. The bridge may include, for example, silicon oxide, silicon nitride, aluminum oxide, hafnium oxide, zirconium oxide, or a 2D insulator such as h-BN. The bridge may include, for example, a material for forming the aforementioned gate insulating layer and/or capacitor dielectric layer.

Next, the first interlayer (not shown) may be disposed on one surface of the first thin-film electrode 11 or the second thin-film electrode 13 by epitaxy growth.

The epitaxial growth may be, for example, performed by using a molecular beam epitaxy process, a pulsed laser epitaxy process, a vapor epitaxy process, a gaseous phrase epitaxy process, or the like.

When the first interlayer (not shown) is formed by using a pulsed laser deposition epitaxy process, for example, after a laminate of the dielectric substrate 100/first thin-film electrode 11 is loaded into a reaction chamber, the first thin-film electrode 11 may be maintained at a temperature in a range of about 400 °C to about 800 °C, and a partial pressure of an oxidizing agent, such as an oxygen-partial pressure, may be maintained at a pressure in a range of 0.01 mbar to 1 mbar in the chamber. By vaporizing metals and/or metal ions from a metal precursor, gaseous metals and/or gaseous metal ions constituting the first interlayer (not shown) may be supplied. Subsequently, the gaseous metals and/or gaseous metal ions may be introduced onto the dielectric substrate 100, and an oxidizing agent may be supplied to form the first interlayer (not shown). When the first interlayer (not shown) includes GaO₂, the metal precursor may include, consist of, or consist essentially of gallium or a gallium-containing first precursor compound, and the oxidizing agent may include oxygen (O₂), ozone (O₃), nitrogen dioxide (NO₂), or dinitrogen oxide (N₂O). The oxidizing agent may be, for example, oxygen.

When the first interlayer (not shown) is formed by using a molecular beam epitaxy process, after a laminate of the dielectric substrate 100/first thin-film electrode 11 manufactured as described above is loaded into a reaction chamber, the first thin-film electrode 11 may be maintained at a temperature in a range of about 400 °C to about 800 °C, and a partial pressure of an oxidizing agent, such as an oxygen-partial pressure, may be maintained at a pressure in a range of 10-8 Torr to 10-5 Torr in the chamber. Gaseous metal for forming the first interlayer may be supplied by vaporizing metal from the metal precursor. Subsequently, the gaseous metal may be introduced onto the surface-treated first thin-film electrode 11, and then an oxidizing agent may be supplied thereto to form a second interlayer (not shown) on the surface-treated first thin-film electrode 11. When the first interlayer (not shown) includes GaO2, the metal precursor may include, consist of, or consist essentially of gallium or a gallium-containing first precursor compound, and the oxidizing agent may include oxygen (O₂), ozone (O₃), nitrogen dioxide (NO₂), or dinitrogen oxide (N₂O). The oxidizing agent may be, for example, oxygen.

Although not shown in the drawing, the first interlayer (not shown) may be simultaneously disposed on one surface of the multiple first electrodes 11 and on the bridge disposed between the multiple first electrodes 11 by epitaxy growth. Because the first interlayer (not shown) is a dielectric layer, the step of removing the first interlayer (not shown) disposed on the bridge (not shown) will be omitted. Consequently, the capacitor manufacturing process may be simplified.

Next, the dielectric layer 14 may be disposed on one surface of the interlayer (not shown) by epitaxy growth.

The epitaxial growth may be, for example, performed by using a molecular beam epitaxy process, a pulsed laser epitaxy process, a vapor epitaxy process, a gaseous phrase epitaxy process, or the like.

The dielectric layer 13 may be selected from, for example, titanium oxide (TiO₂), Ga-doped titanium oxide (Ti₁₋ₓGaₓO₂, 0.01 ≤x≤0.1), Al-doped titanium oxide (Ti₁₋ₓAlₓO₂, 0.01 ≤x≤0.1), La-doped titanium oxide (Ti₁₋ₓLaₓO₂, 0.01 ≤x≤0.1), B-doped titanium oxide (Ti₁₋ₓBₓO₂, 0.01≤x≤0.1), In-doped titanium oxide (Ti₁₋ₓInₓO₂, 0.01≤x≤0.1), Sc-doped titanium oxide (Ti₁₋ₓScₓO₂, 0.01 ≤x≤0.1), and Y-doped titanium oxide (Ti₁₋ₓYₓO₂, 0.01≤x≤0.1).

When the dielectric layer 13 is formed by using an atomic layer deposition (ALD) method, after a laminate of the dielectric substrate 100/first thin-film electrode 11/first interlayer (not shown) prepared according to the method described above is loaded into a reaction chamber, the first thin-film electrode 11 may be maintained at a temperature in a range of about 200 °C to about 400 °C, and a concentration of the oxidizing agent in the chamber, for example, an ozone concentration, may be maintained in a range of 100 g/m³ to about 500 g/m³. By vaporizing metals and/or metal ions from a metal precursor, gaseous metals and/or gaseous metal ions constituting the dielectric layer (not shown) may be supplied. Next, the gaseous metal and/or gaseous metal ions may be introduced to the first thin-film electrode 11, and then the oxidizing agent may be supplied to form the dielectric layer 13. When the dielectric layer 13 includes an aluminum (Al) -doped titanium oxide (Ti₁₋ₓAlₓO₂, 0.01 ≤x≤0.1), the metal precursor may include, consist of, or consist essentially of Ti, , a Ti-including first precursor compound, , Al, or an Al-including dopant compound, and the oxidizing agent may include oxygen (O₂), ozone (O₃),nitrogen dioxide (NO₂), nitrous oxide (N₂O), or the like. The oxidizing agent may be, for example, ozone.

The deposition of the dielectric layer 13 may be performed by repeating a third cycle at least once, the third cycle including a first cycle of supplying the first precursor compound and ozone and a second cycle of supplying the dopant compound and ozone. The first cycle may be performed multiple times while the second cycle is performed once. For example, the second cycle may be performed at least one time between the first cycles performed multiple times. In the process of depositing the dielectric layer 13, the first cycle may be performed 2 times to 100 times. In the process of depositing the dielectric layer 13, the first cycle may be, for example, performed 2 times to 50 times, 2 times to 30 times, 2 times to 20 times, or 2 times to 10 times. In the process of depositing the dielectric layer 13, the second cycle may be performed 0.5 time to 10 times. In the process of depositing the dielectric layer 13, the second cycle may be performed 0.5 time, 1 time, 1.5 times, 2 times, 2.5 times, 3 times, 3.5 times, 4 times, 4.5 times, or 5 times. When the dielectric layer 13 does not include a dopant, the second cycle is not performed.

By additionally performing a heat treatment process on the dielectric layer 13, materials constituting the dielectric layer 13 may be additionally crystalized. For example, the dielectric layer 13 may be heat-treated by a rapid heat treatment process (RTP) under an atmosphere of oxygen (O₂) gas, nitrogen (N₂) gas, argon (Ar) gas, ammonia (NH₄) gas, or a mixture thereof. The RTP may be performed, for example, at a temperature of about 500 °C to about 650 °C for about 30 seconds to about 3 minutes.

Next, the other thin-film electrode layers may be disposed on the dielectric layer 13 to provide the capacitor 20.

A method of disposing the first thin-film electrode 11 that is not in contact with the interlayer (not shown) or the second thin-film electrode 12 that is not in contact with the interlayer (not shown) may be the same as the method of disposing the second thin-film electrode 12 that is in contact with the interlayer (not shown) or the first thin-film electrode 11 that is in contact with the interlayer (not shown).

In some example embodiments, the first thin-film electrode 11 that is not in contact with the interlayer (not shown) or the second thin-film electrode 12 that is not in contact with the interlayer (not shown) may be formed by performing heat treatment on a coating film obtained by coating and drying an electrode paste including a conductive material.

A coating method does not use a vacuum process or a high-temperature process, and thus an electrode may be simply manufactured.

The electrode paste may include conductive material particles, an organic component, and a solvent.

For the conductive material, any general material available for an electrode may be used. Examples of the conductive material include conductive metal oxides (e.g., tin oxide, indium oxide, or indium-tin oxide (ITO)), metals such as platinum, gold, silver, copper, iron, tin, zinc, aluminum, indium, chromium, lithium, sodium, potassium, cesium, calcium, magnesium, palladium, molybdenum, or alloys thereof, amorphous silicon, and polysilicon, inorganic conductive materials (e.g., copper iodide, or copper sulfide); complexes of polythiophene, polypyrrole, polyaniline, polyethylenedioxythiophene, or the like with polystyrene sulfonic acid, and carbon materials such as conductive polymers of which the conductivity is improved by doping with iodine. Although the conductive material may be used alone, a plurality of conductive materials may be used in combination by laminating or mixing.

The conductive material may be, for example, metal particles. By using metal particles, the bending resistance of the capacitor may be improved, or a coercive electric field may not increase even when voltages are repeatedly applied. For example, the metal particles may include at least one selected from gold, silver, copper, platinum, lead, tin, nickel, aluminum, tungsten, molybdenum, ruthenium oxide, chromium, titanium, carbon, and indium.

Examples of the organic component include a monomer, an oligomer, a polymer, a photopolymerization initiator, a plasticizer, a leveling agent, a surfactant, a silane coupling agent, a defoamer, a pigment, and a dispersant. In view of improving the bending resistance of the capacitor, for example, the organic component may be an oligomer or a polymer. The oligomer or polymer may be, for example, a thermoplastic resin or a thermosetting resin. Examples of the oligomer or polymer include acrylic resin, epoxy resin, novolak resin, phenol resin, polyimide precursor resin, polyimide resin, polysiloxane resin, fluoride-based resin, and polyvinyl acetal resin.

Any solvent may be used as long as it disperses the dielectric particles and dissolves the organic component. Examples of the solvent include organic solvents, which include ketone-based solvents such as methyl ethyl ketone, acetone, diethyl ketone, methyl isobutyl ketone, methyl isopropyl ketone, cyclopentanone, and cyclohexanone, alcohol-based solvents such as methanol, ethanol, isopropanol, isobutyl alcohol, benzyl alcohol, methoxymethylbutanol, ethylene glycol, diethylene glycol, and glycerin, ether-based solvents such as diethyl ether, diisopropyl ether, 1,2-dimethoxyethane, 1,4-dioxane, tetrahydrofuran, tetrahydropyran, anisole, diethylene glycol dimethyl ether (diglyme), and diethylene glycol ethyl ether (carbitol), cellosolve-based solvents such as methyl cellosolve, ethyl cellosolve, and phenyl cellosolve, aliphatic hydrocarbon-based solvents such as hexane, pentane, heptane, and cyclohexane, aromatic hydrocarbon-based solvents such as toluene, xylene, and benzene, aromatic heterocyclic compound solvents such as pyridine, pyrazine, furan, pyrrole, thiophene, and N-methylpyrrolidone, amide-based solvents such as N, N-dimethylformamide and N, N-dimethylacetamide, halogen compound-based solvents such as trichloroethylene, dichloromethane, chloroform, 1,2-dichloroethane, and chlorobenzene, ester-based solvents such as ethyl acetate, methyl acetate, ethyl formate, ethyl lactate, dimethyl carbonate, diethyl carbonate, propylene carbonate, and γ-butyrolactone, sulfur compound-based solvents such as dimethyl sulfoxide and sulfolane, nitrile-based solvents such as acetonitrile, propionitrile, and acrylonitrile, organic acid-based solvents such as formic acid, acetic acid, trichloroacetic acid, and trifluoroacetic acid, or mixed solvents thereof.

Examples of the coating method include spin coating, blade coating, slit die coating, screen printing, bar coating, casting, gravure printing, flexographic printing, offset printing, dip coating, inkjet printing, and dispensing. Among these coating methods, in view of pattern workability and film formability, for example, screen printing, gravure printing, flexographic printing, offset printing, or inkjet printing, dispensing may be used.

A method of removing a solvent from a coating film may be, for example, heat drying or vacuum drying using an oven, a hot plate, or infrared light, and, for example, may be performed at a temperature of about 50 °C to about 140 °C for about 1 minute to about several hours.

Next, in order to improve electrode characteristics, the coating film may be cured. Here, the curing temperature may be selected depending on types of a conductive material, a solvent used, and types of a substrate. As the curing method, heat curing or vacuum curing using an oven, a hot plate or infrared light, curing using a xenon flash lamp, or photocuring using UV light may be used.

The disclosure is in greater details through Examples and Comparative Examples below. However, the following example embodiments are for illustrative purpose only and shall not be construed as limiting the scope of the disclosure.

### (Preparation of capacitor I)

### Example 1: MoO₂/GeO₂/Al-doped TiO₂/Pt, GeO₂ thickness of 3 Å

By using a PLD method, a MoO₂ thin film was grown on a substrate to form a first thin-film electrode. Here, a thickness of the first thin-film electrode was 200 Å. The MoO₂ thin film had a rutile crystal structure.

By using the same method, a GeO₂ thin film was grown on the first thin-film electrode to form an interlayer. Here, a thickness of the interlayer was 3 Å.

By using an atomic layer deposition (ALD) method, an Al-doped TiO₂ thin film was grown on the interlayer to form a dielectric layer. The Al-doped TiO₂ thin film had a rutile crystal structure. Here, a thickness of the dielectric layer was 50 Å.

By using a vapor deposition method, a Pt thin film was grown on the dielectric layer to form a second thin-film electrode. Here, a thickness of the second thin-film electrode was 200 Å.

### Example 2: MoO₂/GeO₂/Al-doped TiO₂/Pt, 7 Å-thick GeO₂

A capacitor was prepared in the same manner as in Example 1, except that the thickness of the interlayer was changed to 7 Å.

### Example 3: MoO2/GeO2/Al-doped TiO₂/Pt, 11 Å-thick GeO₂

A capacitor was prepared in the same manner as in Example 1, except that the thickness of the interlayer was changed to 11 Å.

### Example 4: MoO2/GeO2/Al-doped TiO₂/Pt, 15 Å-thick GeO2

A capacitor was prepared in the same manner as in Example 1, except that the thickness of the interlayer was changed to 15 Å.

### Evaluation Example 1: TEM analysis

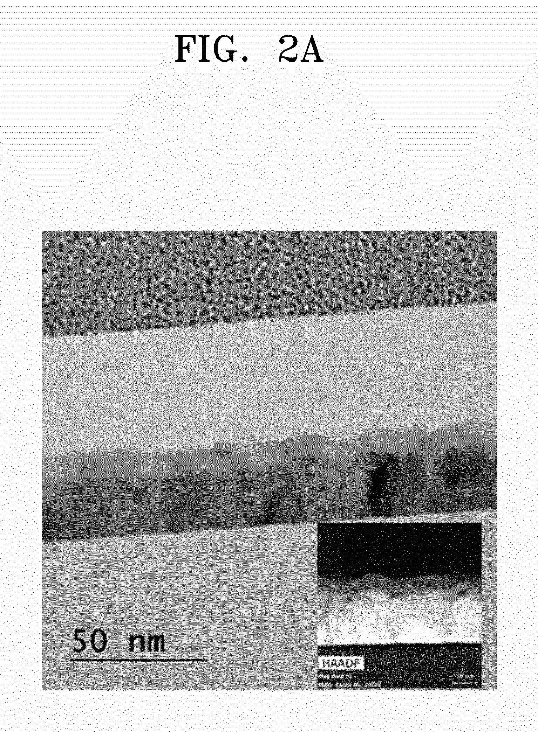

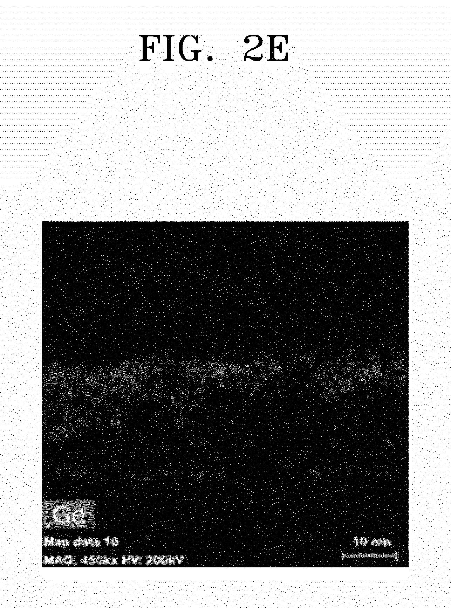

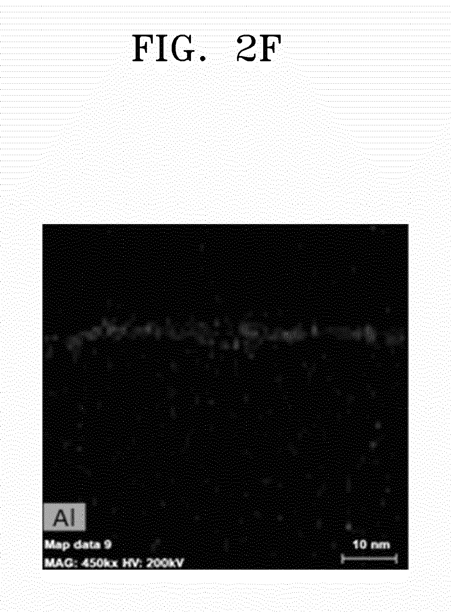

For the cross-section of the laminate of electrode/interlayer/dielectric layer before the Pt thin film was disposed in Example 4, HR-TEM, high-angle annular dark field (HAADF)-STEM, and energy dispersive X-ray spectroscopy (EDS) mapping images were measured, and results thereof are shown in FIGS. 2A to 2F.

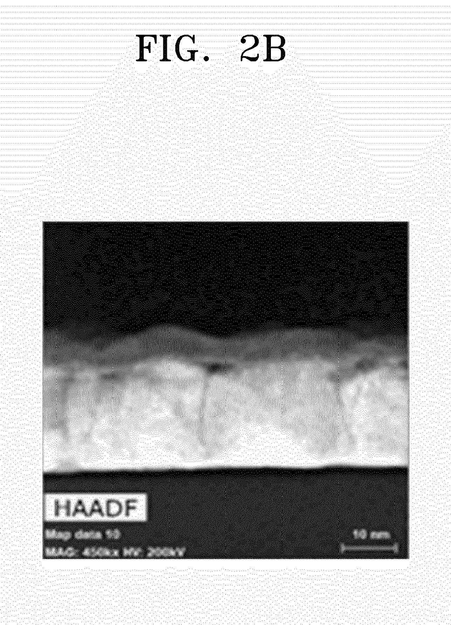

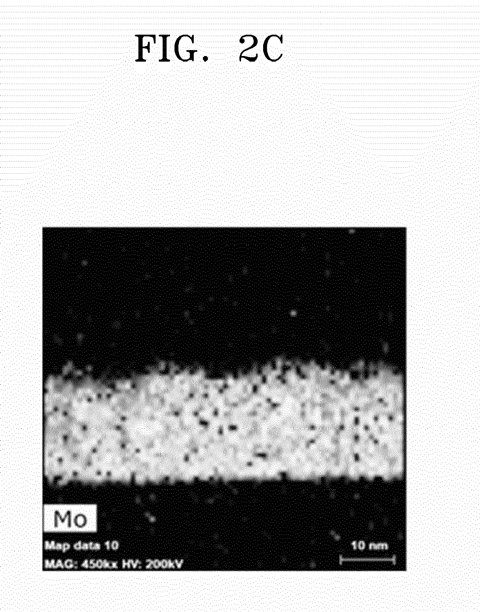

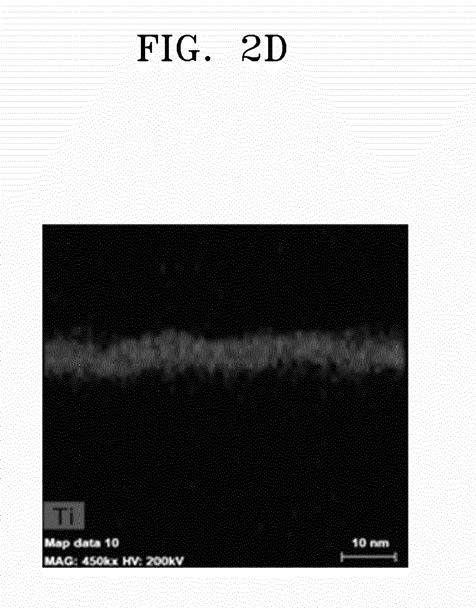

FIG. 2A is an HR-TEM image of a cross-section of a laminate of electrode /interlayer/dielectric layer prepared in Example 4. FIG. 2B is an HAADF-STEM image of a cross-section of a laminate of electrode /interlayer/dielectric layer prepared in Example 4. FIGS. 2C and 2D each show an EDS mapping image of FIG. 2B.

As shown in FIGS. 2A to 2F, GeO₂ interlayer is disposed at an interface between an MoO₂ electrode layer and an Al-doped TiO₂ dielectric layer;

### Evaluation Example 2: XRD analysis

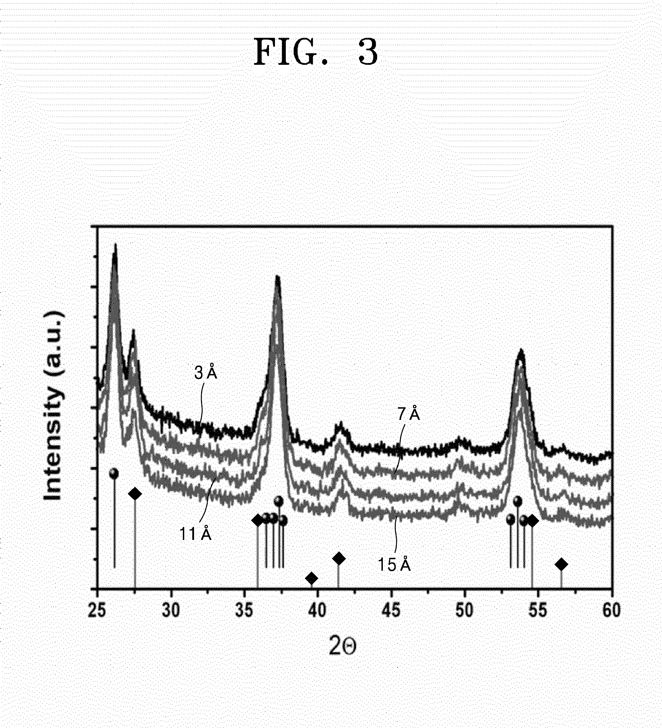

For the laminates of electrode/interlayer/dielectric layer prepared in Examples 1 to 4, grazing incidence X-ray diffraction (GI-XRD) spectra were measured, and results thereof are shown in FIG. 3. For the XRD spectra measurement, Cu Kα radiation was used.

As shown in FIG. 3, regardless of the thickness of the GeO₂ layer, the Al-doped TiO₂ dielectric layer having a rutile crystal structure was formed.

In FIG. 3, circles represent positions of peaks derived from MoO₂, and diamonds represent positions of peaks derived from TiO₂ having a rutile structure.

It is confirmed that the rutile crystal structure of TiO₂ grew regardless of the change in the thickness of the GeO₂ interlayer.

### (Preparation of capacitor II)

### Example 5: MoO₂/GeO₂/TiO₂/Pt

By using a PLD method, a MoO₂ thin film was grown on a substrate to form a first thin-film electrode. Here, a thickness of the first thin-film electrode was 200 Å. The MoO₂ thin film had a rutile crystal structure.

By using the same method, a GeO₂ thin film was grown on the first thin-film electrode to form an interlayer. Here, a thickness of the interlayer was 7 Å.

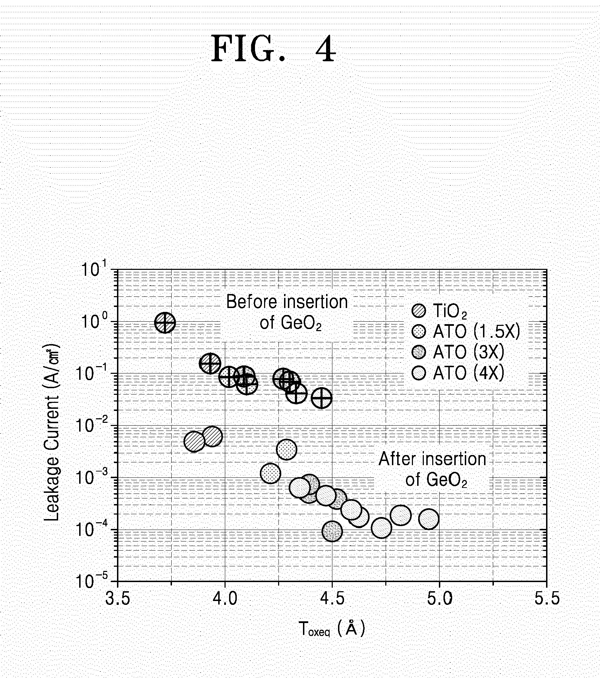

By using an ALD method, a TiO₂ thin film was grown on the interlayer to form a dielectric layer. The MoO₂TiO₂ thin film had a rutile crystal structure. The thickness of the dielectric layer has been variously changed. The thickness of the dielectric layer is represented by equivalent oxide thickness (EOT, T_{oxeq}) in FIG. 4.

By using a vapor deposition method, a Pt thin film was grown on the dielectric layer to form a second thin-film electrode. Here, a thickness of the second thin-film electrode was 200 Å.

### Example 6: MoO₂/GeO₂/Al-doped TiO₂/Pt, Al₂O₃ inserted 1.5 times

A capacitor was prepared in the same manner as in Example 5, except that Al-doped TiO₂ was used instead of TiO₂.

During the ALD deposition, the number of insertions of Al₂O₃ was 1.5 times.

### Example 7: MoO₂/GeO₂/Al-doped TiO₂/Pt, Al₂O₃ inserted 3 times

A capacitor was prepared in the same manner as in Example 5, except that Al-doped TiO₂ was used instead of TiO₂ and the number of insertions of Al₂O₃ was changed to 3 times.

### Example 8: MoO₂/GeO₂/Al-doped TiO₂/Pt, Al₂O₃ inserted 4 times

A capacitor was prepared in the same manner as in Example 5, except that Al-doped TiO₂ was used instead of TiO₂ and the number of insertions of Al₂O₃ was changed to 4 times.

### Comparative Example 1: MoO₂/TiO₂/Pt

A capacitor was prepared in the same manner as in Example 5, except that the GeO₂ interlayer was not included.

Comparative Example 2: MoO₂/Al-doped TiO₂/Pt, Al₂O₃ inserted 1.5 times.

A capacitor was prepared in the same manner as in Example 6, except that the GeO₂ interlayer was not included.

### Comparative Example 2: MoO₂/Al-doped TiO₂/Pt, Al₂O₃ inserted 3 times.

A capacitor was prepared in the same manner as in Example 7, except that the GeO₂ interlayer was not included.

### Comparative Example 2: MoO₂/Al-doped TiO₂/Pt, Al₂O₃ inserted 4 times.

A capacitor was prepared in the same manner as in Example 8, except that the GeO₂ interlayer was not included.

### Evaluation Example 3: Measurement of leakage current

For the capacitors prepared in Examples 5 to 8 and Comparative Examples 1 to 4, leakage current according to the thickness of the dielectric layer was measured. Results of the measurement are shown in FIG. 4.

In FIG. 4, the thickness of the dielectric layer is represented by an equivalent oxide thickness (EOT) T_{oxeq}. The leakage current refers to current density when a voltage of 1 V was applied to the capacitor.

As shown in FIG. 4, the leakage current in the capacitors of Examples 5 to 8 in which the GeO₂ interlayer was added was reduced by two or three orders of magnitude compared to the capacitors of Comparative Examples 1 to 4 in which the GeO₂ interlayer was not included.

Therefore, it is confirmed that the leakage current was reduced by the introduction of the GeO₂ interlayer.

### Evaluation Example 4: Measurement of capacitance and dissipation factor

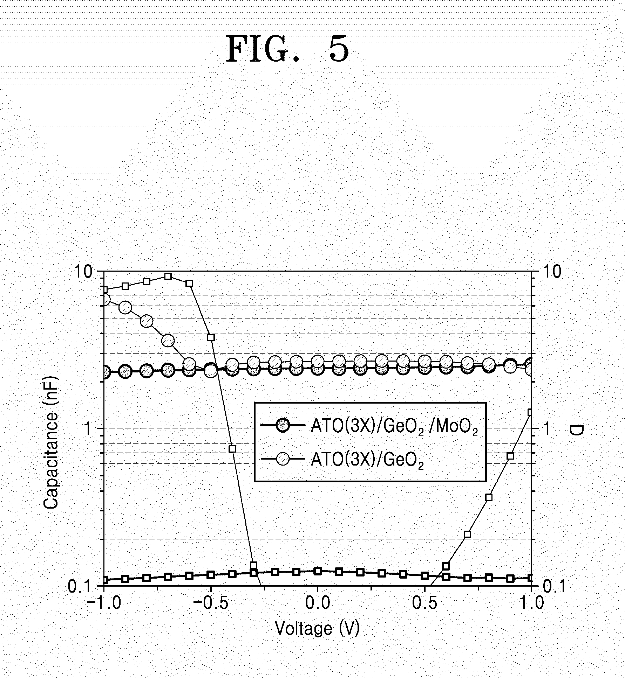

For the capacitors prepared in Example 7 and Comparative Example 3, voltage-dependent capacitance and dissipation factor (DF) were measured, and results thereof are shown in FIG. 5.

As shown in FIG. 5, the capacitor of Example 7 had little change in capacitance and dissipation factor within a voltage range of -1.0 V to 1.0 V.

Meanwhile, the capacitor of Comparative Example 3 had an increase in the dissipation factor at a voltage of -0.25 V or less and 0.5 V or more.

Therefore, it is confirmed that the dielectric loss of the capacitor of Example 7 was suppressed compared to the capacitor of Comparative Example 3.

### Evaluation Example 5: Calculation results of chemical potential

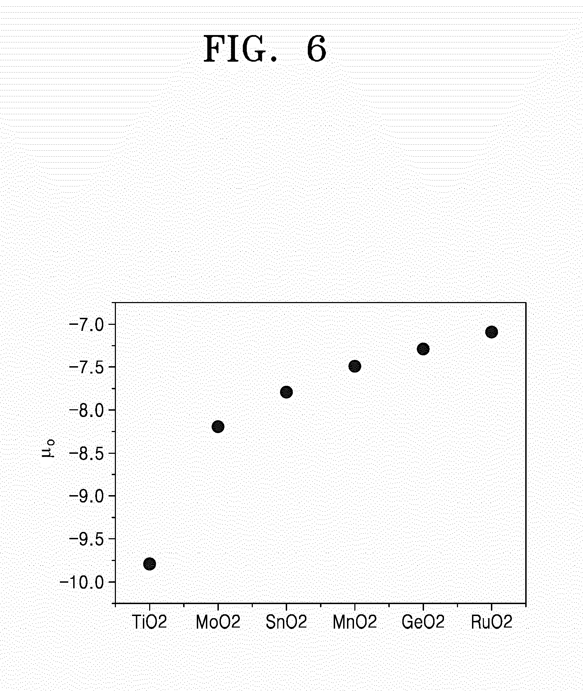

For TiO₂, MoO₂, SnO₂, MnO₂, GeO₂, and RuO₂ that are binary oxides having a rutile crystal structure, chemical potential (µₒ) was calculated, and results thereof are shown in FIG. 6. A unit of the chemical potential is electronvolt (eV).

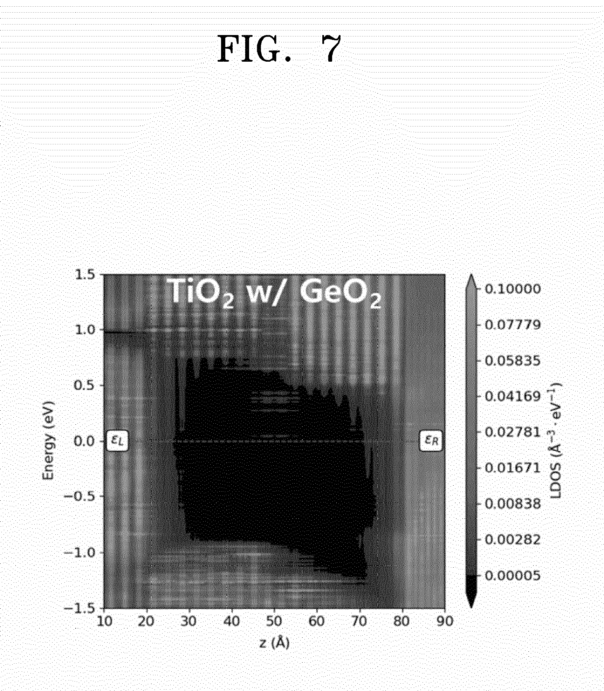

FIG. 7 shows the calculation results of density of state (DOS) when the GeO₂ layer was inserted between the TiO₂ layers.

The chemical potential and DOS were calculated based on the density functional theory (DFT) framework using the Vienna Ab initio Simulation Package (VASP).

As shown in FIG. 6, it was confirmed that the chemical potential of GeO₂ was higher than that of MoO₂, and the chemical potential of MoO₂ was higher than that of TiO₂.

Thus, when the GeO₂ interlayer is disposed on the MoO₂ electrode layer and then the TiO₂ dielectric layer is deposited on the GeO₂ interlayer, the chemical potential of GeO₂ is higher than the chemical potential of MoO₂, and thus oxygen ions transfer not from MoO₂ to TiO₂ but from GeO₂ to TiO₂, and accordingly a reduction of MoO₂ may be suppressed. Accordingly, by disposing the GeO₂ interlayer on the MoO₂ electrode having a rutile structure, the degradation of work function by the reduction of MoO₂ during the manufacturing of the capacitor including the TiO₂ dielectric layer may be mitigated or prevented. Consequently, the deterioration of the MoO₂ electrode may be mitigated or prevented.

### (Preparation of capacitor III)

### Example 9: MoO₂/GeO₂/Al-doped TiO₂/Pt, 7 Å-thick GeO₂

By using a PLD method, a MoO₂ thin film was grown on a substrate to form a first thin-film electrode. Here, a thickness of the first thin-film electrode was 200 Å. The MoO₂ thin film had a rutile crystal structure.

By using the same method, a GeO₂ thin film was grown on the first thin-film electrode to form an interlayer. Here, a thickness of the interlayer was 7 Å.

By using an atomic layer deposition (ALD) method, an Al-doped TiO₂ thin film was grown on the interlayer to form a dielectric layer. The Al-doped TiO₂ thin film had a rutile crystal structure. Here, the number of insertion of Al₂O₃ was 5.

By using a vapor deposition method, a Pt thin film was grown on the dielectric layer to form a second thin-film electrode. Here, a thickness of the second thin-film electrode was 200 Å.

### Examples 10 to 14: MoO₂/GeO₂/Al-doped TiO₂/Pt, 10 Å to 20 Å-thick GeO₂

Capacitors were prepared in the same manner as in Example 9, except that the thickness of the GeO₂ interlayer was changed from 7 Å to 10 Å, 12 Å, 15 Å, 17 Å, and 20 Å, respectively.

### Comparative Example 5: MoO₂/Al-doped TiO₂/Pt, GeO₂-free

A capacitor was prepared in the same manner as in Example 5, except that the GeO₂ interlayer was not introduced.

### Evaluation Example 6: Measurement of leakage current

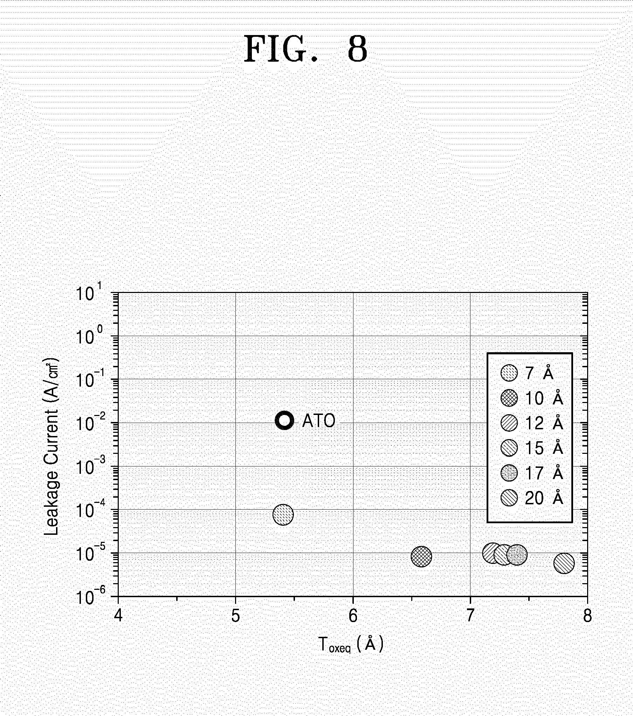

For the capacitors prepared in Examples 9 to 14 and Comparative Example 5, leakage current according to the thickness of the GeO₂ interlayer was measured. Results of the measurement are shown in FIG. 8.

In FIG. 8, the thickness of the dielectric layer is represented by EOT. The leakage current refers to current density when a voltage of 1 V was applied to the capacitor.

As shown in FIG. 8, the leakage current in the capacitors of Examples 9 to 14 in which the GeO₂ interlayer was introduced was reduced by two or three orders of magnitude compared to the capacitor of Comparative Example 5 in which the GeO₂ interlayer was not introduced.

Therefore, it is confirmed that the leakage current was reduced by the introduction of the GeO₂ interlayer. However, when the thickness of the GeO₂ interlayer is excessively increased, the GeO₂ interlayer may act as a dielectric layer so that the dielectric permittivity of the capacitor may be degraded.

### (Preparation of capacitor IV)

### Reference Example 1: MoO₂/Al-doped TiO₂/Pt

By using a PLD method, a MoO₂ thin film was grown on a substrate to form a first thin-film electrode. Here, a thickness of the first thin-film electrode was 200 Å. The MoO₂ thin film had a rutile crystal structure.

By using an ALD method, an Al-doped TiO₂ thin film was grown on the first thin-film electrode to form a dielectric layer. The Al-doped TiO₂ thin film had a rutile crystal structure. Here, the number of insertion of Al₂O₃ was 1.

The thickness of the dielectric layer has been variously changed. The thickness of the dielectric layer is represented by EOT (T_{oxeq}) in FIG. 8.

By using a vapor deposition method, a Pt thin film was grown on the dielectric layer to form a second thin-film electrode. Here, a thickness of the second thin-film electrode was 200 Å.

### Reference Example 2: RuO₂/Al-doped TiO₂/Pt

A capacitor was prepared in the same manner as in Reference Example 1, except that a RuO₂ electrode was used instead of the MoO₂ electrode.

### Evaluation Example 7: Measurement of leakage current

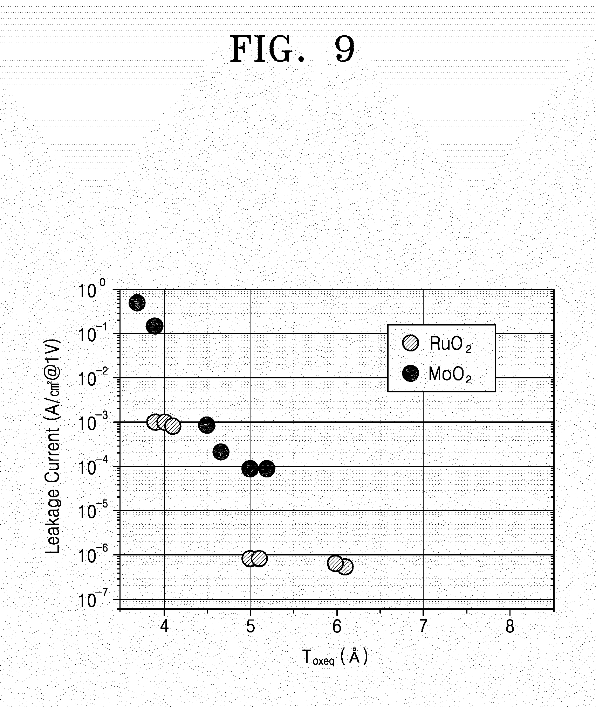

For the capacitors prepared in Reference Examples 1 and 2, leakage current according to the thickness of the GeO₂ interlayer was measured. Results of the measurement are shown in FIG. 9.

In FIG. 9, the thickness of the dielectric layer is represented by EOT. The leakage current refers to current density when a voltage of 1 V was applied to the capacitor.

As shown in FIG. 9, the MoO₂ electrode in the capacitor to which the GeO₂ interlayer was not introduced had poor leakage characteristics compared to the RuO₂ electrode.

The reason for the poor leakage characteristics was determined that, in the process of depositing the Al-doped TiO₂ dielectric layer on the MoO2 electrode, some of MoO₂ were reduced to Mo so that work function of the electrode was reduced and the leakage current increased, whereas such reduction was suppressed in RuO₂ in which Ru was noble metal. Meanwhile, the RuO₂ electrode has a problem of being easily reduced to metal at the time of forming gas annealing in a black end of line (BEOL) process of the DRAM manufacturing process, causing a change in the volume of the device.

According to the one or more example embodiments, a capacitor having a new structure has reduced leakage current, and thus deterioration of an electrode including the capacitor may be suppressed during a device manufacturing process.

Any functional blocks shown in the figures and described above may be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that some example embodiments described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. A capacitor comprising:
a first thin-film electrode layer;
a second thin-film electrode layer;
a dielectric layer between the first thin-film electrode layer and the second thin-film electrode layer; and
a first interlayer being at least one of between the first thin-film electrode layer and the dielectric layer and between the second thin-film electrode layer and the dielectric layer, the first interlayer including first metal oxide,
wherein at least one of the first thin-film electrode layer and the second thin-film electrode layer includes second metal oxide having a rutile crystal structure and including non-noble metal,
the dielectric layer includes third metal oxide having a dielectric rutile crystal structure,
the first metal oxide, the second metal oxide, and the third metal oxide have different compositions from one another,
the first metal oxide includes GeO₂, and the third metal oxide includes TiO₂,
and
a thickness of the first interlayer is smaller than that of the dielectric layer.

2. The capacitor of claim 1, wherein
the capacitor comprises multiple first thin-film electrode layers that are spaced apart or multiple second thin-film electrode layers that are spaced apart,
the capacitor further comprises a bridge connecting the multiple first thin-film electrode layers to each other or connecting the multiple second thin-film electrode layers to each other, and
the first interlayer is on the bridge, and optionally wherein
the first interlayer extends from at least one of the multiple first thin-film electrode layers to another adjacent one of the multiple first thin-film electrode layers through the bridge or from at least one of the multiple second thin-film electrode layers to another adjacent one of the multiple second thin-film electrode layers through the bridge, and
the first interlayer is dielectric.

3. The capacitor of claim 1 or 2, wherein the thickness of the first interlayer is smaller than at least one of that of the first thin-film electrode layer and that of the second thin-film electrode layer.

4. The capacitor of any preceding claim, wherein the thickness of the first interlayer is 1 Å or more to less than 20 Å.

5. The capacitor of any preceding claim, wherein
chemical potential of the first metal oxide is higher than that of the second metal oxide and that of the third metal oxide, and
chemical potential of the second metal oxide is higher than that of the third metal oxide.

6. The capacitor of any preceding claim, wherein the first interlayer has a defect, and the defect includes oxygen vacancy.

7. The capacitor of any preceding claim, wherein the first metal oxide further comprises at least one selected from SnO₂, MnO₂, GeO₂₋ₐ (1<a<2), SnO₂₋ₐ (1<a<2), and MnO₂₋ₐ (1<a<2).

8. The capacitor of any preceding claim, wherein the second metal oxide comprises at least one selected from MoO₂, SnO₂, Sn₁₋ₓTaₓO₂ (0.01≤x≤0.1 ), Sn₁₋ₓNbₓO₂ (0.01≤x≤0.1), Sn₁₋ₓSbₓO₂ (0.01≤x≤0.1), Sn₁₋ₓMnₓO₂ (0.01≤x≤0.1), and Sn₁₋ₓFeₓO₂ (0.01≤x≤0.1).

9. The capacitor of any preceding claim, wherein the third metal oxide comprises at least one selected from Ti_{1-y}Ga_{y}O₂ (0.01≤y≤0.1), Ti_{1-y}Al_{y}O₂ (0.01≤y≤0.1), Ti_{1-y}La_{y}O₂ (0.01≤y≤0.1), Ti_{1-y}B_{y}O₂ (0.01≤y≤0.1), Ti_{1-y}In_{y}O₂ (0.01≤y≤0.1), Ti_{1-y}Sc_{y}O₂ (0.01≤y≤0.1), and Ti_{1-y}Y_{y}O₂ (0.01≤y≤0.1).

10. The capacitor of any preceding claim, wherein
a thickness of the dielectric layer is in a range of 2 nm to 100 nm, and
a thickness of each of the first thin-film electrode layer and the second thin-film electrode layer is in a range of 10 nm to 1,000 nm.

11. The capacitor of any preceding claim, wherein
at least one of the first thin-film electrode layer and the second thin-film electrode layer has a multi-layer structure, and
the capacitor further comprises a second interlayer between multiple sub-electrodes that constitute at least one of the first thin-film electrode layer and second thin-film electrode layer.

12. The capacitor of any preceding claim, wherein
at least one of the first thin-film electrode layer and the second thin-film electrode layer that is not in contact with the first interlayer comprises at least one selected from metal, oxide of the metal, doped oxide of the metal, nitride of the metal, and carbide of the metal,
the metal comprises at least one selected from Ti, W, Ta, Co, Mo, Ni, V, Hf, Al, Cu, Pt, Pd, Ir, Au, and Ru,
the oxide of the metal comprises at least one selected from MoO₂, VO₂, RuO₂, IrO₂, PtO₂, MnO₂, Sb₂O₃, In₂O₃,
the doped oxide of the metal comprises at least one selected from Ta-doped SnO₂, Sb-doped SnO₂, Ni-doped SnO₂, Ti-doped In₂O₃, Ni-doped SnO₂, Sb-doped SnO₂, and Al-doped ZnO, and
the nitride of the metal comprises at least one selected from TiN, WN, VN, MoN, TaN, TiAlN, TaSiN, TiSiN, WSiN, TiCN, TiAlCN, RuCN, and RuTiN.

13. An electronic device comprising:
a transistor; and
a capacitor according to any preceding claim electrically connected to the transistor.

14. A method of preparing a capacitor, the method comprising:
providing one of a first thin-film electrode layer and a second thin-film electrode layer;
first-disposing a first interlayer on one surface of the provided one of the first thin-film electrode layer and the second thin-film electrode layer, by epitaxy growth;
second-disposing a dielectric layer on the first interlayer by epitaxy growth; and
third-disposing the other one of the first thin-film electrode layer and the second thin-film electrode layer on the dielectric layer to provide the capacitor, which includes the first thin-film electrode layer, a second thin-film electrode layer, a dielectric layer disposed between the first thin-film electrode layer and the second thin-film electrode layer,
wherein the first interlayer includes first metal oxide,
at least one of the first thin-film electrode layer and the second thin-film electrode layer includes second metal oxide having a rutile crystal structure and including non-noble metal,
the dielectric layer includes third metal oxide having a dielectric rutile crystal structure,
the first metal oxide, the second metal oxide, and the third metal oxide have different compositions from one another,
the first metal oxide includes GeO₂, and the third metal oxide includes TiO₂,
and
a thickness of the first interlayer is smaller than that of the dielectric layer.

15. The method of claim 14, wherein
the providing and the first-disposing comprise:
providing multiple first thin-film electrode layers that are spaced apart or multiple second thin-film electrode layers that are spaced apart;
disposing a bridge at least one of between the multiple first thin-film electrode layers to connect the multiple first thin-film electrode layers to each other and between the multiple second thin-film electrode layers to connect the multiple second thin-film electrode layers to each other; and
simultaneously disposing the first interlayer by epitaxy growth on one surface of the multiple first thin-film electrode layers or the multiple second thin-film electrode layers and on the bridge disposed between the multiple first thin-film electrode layers or between the multiple second thin-film electrode layers.
